# EUROPEAN PATENT APPLICATION

(11) **EP 2 469 331 A1**
(43) Date of publication of application: **27.06.2012**
(21) Application number: 10809785.8
(22) Date of filing: 25.06.2010
(51) Int. Cl.: G02F 1/1368, C22C 21/00, G02F 1/1343, G09F 9/30, H01L 21/28, H01L 21/336, H01L 29/417, H01L 29/423, H01L 29/49, H01L 29/786

(54) **LIQUID CRYSTAL DISPLAY DEVICE AND METHOD FOR MANUFACTURING LIQUID CRYSTAL DISPLAY DEVICE**

(30) Priority: 21.08.2009 JP 2009192357
(71) Applicant: Sharp Kabushiki Kaisha, Osaka-shi, Osaka 545-8522 (JP)
(72) Inventor: NAKAHARA, Hijiri, Osaka-shi, Osaka 545-8522 (JP); NAKATA, Yukinobu, Osaka-shi, Osaka 545-8522 (JP)
(74) Representative: Müller - Hoffmann & Partner
(86) International application number: PCT/JP2010/060881
(87) International publication number: WO 2011/021439

(57) **Abstract**

At least one of a drain electrode (136), a source electrode (135) and a gate electrode (132) includes an aluminum alloy material film. The aluminum alloy material film includes aluminum as a base material, an alloy component containing at least one type of element selected from the group consisting of cobalt, rhodium, nickel, palladium, carbon, silicon, germanium, and tin, and another component containing an element different from aluminum and each element listed above, in which the total number of types of the elements of the alloy component and another component is three or more.

## Description

### TECHNICAL FIELD

The present invention relates a liquid crystal display device and a method of manufacturing the liquid crystal display device.

### BACKGROUND ART

Various types of liquid crystal display devices have been conventionally proposed. For example, the liquid crystal display device disclosed in Japanese Patent Laying-Open No. 09-197433 (PTL 1) includes a transparent substrate, a gate electrode and a gate pad formed on this substrate, a source electrode, and a drain electrode.

The gate pad includes a metal film formed of aluminum (Al) and the like, and a metal film formed on this metal film and formed of titanium (Ti) and the like. The source electrode and the drain electrode each are also formed of titanium and the like.

Furthermore, Japanese Patent Laying-Open No. 2004-214606 (PTL 2) also discloses a display device using an aluminum alloy film.

### CITATION LIST

### PATENT LITERATURE

PTL 1: Japanese Patent Laying-Open No. 09-197433
PTL 2: Japanese Patent Laying-Open No. 2004-214606

### SUMMARY OF INVENTION

### TECHNICAL PROBLEM

In the process of manufacturing the above-described conventional liquid crystal display device, it becomes necessary to pattern titanium (Ti) when a gate electrode, a source electrode and a drain electrode are formed.

When patterning titanium (Ti), plasma dry etching is employed. When titanium (Ti) is patterned by dry etching, fine titanium dust is produced within the chamber.

When the titanium dust falls onto the substrate, the gate electrode and the like cannot be accurately patterned, leading to a significant decrease in the yield.

The present invention has been made in light of the above-described problems. An object of the present invention is to provide a liquid crystal display device and a method of manufacturing the liquid crystal display device that allow improvement in the yield.

### SOLUTION TO PROBLEM

A liquid crystal display device according to the present invention includes a substrate including a pixel array region and a peripheral region located outside of the pixel array region; a switching element formed in the pixel array region; an electrode provided in the switching element; a lead line connected to the switching element; and a pad portion connected to the lead line. At least one of the electrode, the lead line and the pad portion includes an aluminum alloy material film. The aluminum alloy material film includes aluminum as a base material, an alloy component containing at least one type of element selected from the group consisting of cobalt, rhodium, nickel, palladium, carbon, silicon, germanium, and tin, and another component containing an element different from aluminum and each element listed above, in which a total number of types of the elements of the alloy component and another component is three or more.

Preferably, the aluminum alloy material film contains 0.5 wt% or more of the alloy component.

Preferably, the alloy component contained in the aluminum alloy material film is 4.5 wt% or less. Preferably, the aluminum alloy material film contains a conductive precipitate.

Preferably, the electrode of the switching element includes a drain electrode and further includes a pixel electrode connected to the drain electrode. The drain electrode includes the aluminum alloy material film. The pixel electrode is connected to the aluminum alloy material film of the drain electrode. The precipitate is exposed in at least a portion of a surface of the aluminum alloy material film that is in contact with the pixel electrode.

Preferably, the switching element further includes a semiconductor layer. The electrode of the switching element includes a source electrode and a drain electrode formed on the semiconductor layer. The drain electrode and the source electrode each include the aluminum alloy material film and a metal film disposed between the aluminum alloy material film and the semiconductor layer. The metal film is formed of an element greater in density than the element of the alloy component and the element of another component.

Preferably, the drain electrode and the source electrode each further include an intermediate film formed of aluminum and formed between the aluminum alloy material film and the metal film. Preferably, the metal film is formed of molybdenum.

Preferably, the pad portion is formed of the aluminum alloy material film. Preferably, a transparent conductive film formed on the pad portion is further included. The pad portion is formed of the aluminum alloy material film. The aluminum alloy material film includes a conductive precipitate. The conductive precipitate is exposed in a portion of a surface of the pad portion that is in contact with the transparent conductive film.

Preferably, the electrode of the switching element includes a source electrode and a drain electrode. The pad portion is formed of a first aluminum alloy material film. The source electrode and the drain electrode each are formed of a second aluminum alloy material film. The first aluminum alloy material film includes aluminum as a base material, a first alloy component containing at least one type of element selected from the group consisting of cobalt, rhodium, nickel, palladium, carbon, silicon, germanium, and tin, and a first another component containing an element different from aluminum and each element listed above, in which a total number of types of the elements of the first alloy component and the first another component is three or more. The second aluminum alloy material film includes aluminum as a base material, a second alloy component containing at least one type of element selected from the group consisting of cobalt, rhodium, nickel, palladium, carbon, silicon, germanium, and tin, and a second another component containing an element different from aluminum and each element listed above, in which a total number of types of the elements of the second alloy component and the second another component is three or more. The first aluminum alloy material film includes a conductive first precipitate, and the second aluminum alloy material film includes a conductive second precipitate. The first precipitate is greater in distribution density than the second precipitate.

Preferably, the electrode of the switching element includes a source electrode and a gate electrode. The lead line includes a source line connected to the source electrode and a gate line connected to the gate electrode. The pad portion includes a source pad connected to the source line and a gate pad connected to the gate line. The source pad and the gate pad each are formed of the first aluminum alloy material film.

Preferably, the switching element includes a gate electrode formed on a main surface of the substrate, a semiconductor layer formed on the gate electrode, a source electrode formed on the semiconductor layer, and a drain electrode formed on the semiconductor layer and spaced apart from the source electrode. The lead line includes a gate line connected to the gate electrode, and a source line connected to the source electrode. The pad portion includes a gate pad connected to the gate line, and a source pad connected to the source line. The gate electrode, the gate line and the gate pad each are formed of the aluminum alloy material film.

Preferably, the source electrode, the drain electrode and the source pad each include the aluminum alloy material film.

A liquid crystal display device according to the present invention includes a substrate including a pixel array region and a peripheral region located outside of the pixel array region; a switching element formed in the pixel array region; an electrode provided in the switching element; a lead line connected to the switching element; a pad portion connected to the lead line; and a transparent conductive film formed on the pad portion. At least one of the electrode, the lead line and the pad portion includes an aluminum alloy material film. A potential difference between the aluminum alloy material film and the transparent conductive film is smaller than a potential difference between an aluminum film and the transparent conductive film.

A liquid crystal display device according to the present invention includes a substrate including a pixel array region and a peripheral region located outside of the pixel array region; a switching element formed in the pixel array region; an electrode provided in the switching element; a lead line connected to the switching element; and a pad portion connected to the lead line. At least one of the electrode, the lead line and the pad portion includes an aluminum alloy material film. The aluminum alloy material film includes aluminum as a base material, an alloy component containing at least one type of element selected from the group consisting of cobalt (Co), rhodium (Rh), nickel (Ni), palladium (Pd), carbon (C), silicon (Si), germanium (Ge), and tin (Sn), and another component containing at least one type of element selected from the group consisting of copper (Cu), a lanthanum (La), boron (B), neodymium (Nd), silver (Ag), gold (Au), platinum (Pt), yttrium (Y), niobium (Nb), tungsten (W), and zirconium (Zr).

A method of manufacturing a liquid crystal display device according to the present invention provides a method of manufacturing a liquid crystal display device including a substrate including a pixel array region and a peripheral region located outside of the pixel array region; a switching element formed in the pixel array region; an electrode provided in the switching element; a lead line connected to the switching element; a pad portion connected to the lead line. The method includes the steps of: preparing a substrate having a main surface; forming an aluminum alloy material film including aluminum as a base material, an alloy component containing at least one type of element selected from the group consisting of cobalt, rhodium, nickel, palladium, carbon, silicon, germanium, and tin, and another component containing an element different from aluminum and each element listed above, in which a total number of types of the elements of the alloy component and another component is three or more; and patterning the aluminum alloy material film to form at least one of the electrode, the lead line and the pad portion.

Preferably, the aluminum alloy material film contains 0.5 wt% or more of the alloy component.

Preferably, the alloy component contained in the aluminum alloy material film is 4.5 wt% or less. Preferably, the electrode is formed by patterning the aluminum alloy material film by wet etching. The method preferably further includes the steps of: heating the aluminum alloy material film to form a precipitate within the aluminum alloy material film; exposing the precipitate on a surface of the aluminum alloy material film; and forming a transparent conductive film in a portion of the surface of the aluminum alloy material film in which the precipitate is exposed.

Preferably, the step of forming the electrode includes the steps of: forming the aluminum alloy material film on the main surface of the substrate; and patterning the aluminum alloy material film to form a gate electrode, in which case the electrode is the gate electrode.

Preferably, the method further includes the step of forming a gate insulating film so as to cover the gate electrode. A conductive precipitate is formed within the aluminum alloy material film by heat for forming the gate insulating film.

Preferably, the method further includes the steps of: forming a gate electrode on the main surface of the substrate; forming a gate insulating film so as to cover the gate electrode; forming a semiconductor layer on the gate insulating film and above the gate electrode; and forming, on the semiconductor layer, a metal film formed of an element greater in density than the element of the alloy component and the element of another component. The step of forming the electrode includes the steps of: forming the aluminum alloy material film on the metal film; and patterning the aluminum alloy material film to form a source electrode and a drain electrode each as the electrode.

Preferably, the metal film is formed of molybdenum. Preferably, the method further includes the step of forming an insulating film so as to cover the source electrode and the drain electrode, in which a precipitate is formed within the source electrode and the drain electrode by heat for forming the insulating film.

A method of manufacturing a liquid crystal display device according to the present invention provides a method of manufacturing a liquid crystal display device including a substrate including a pixel array region and a peripheral region located outside of the pixel array region, a switching element formed in the pixel array region, an electrode provided in the switching element, a lead line connected to the switching element, and a pad portion connected to the lead line. The method includes the steps of: preparing a substrate having a main surface; forming an aluminum alloy material film including aluminum as a base material, an alloy component containing at least one type of element selected from the group consisting of cobalt (Co), rhodium (Rh), nickel (Ni), palladium (Pd), carbon (C), silicon (Si), germanium (Ge), and tin (Sn), and another component containing at least one type of element selected from the group consisting of copper (Cu), lanthanum (La), boron (B), neodymium (Nd), silver (Ag), gold (Au), platinum (Pt), yttrium (Y), niobium (Nb), tungsten (W), and zirconium (Zr); and patterning the aluminum alloy material film to form at least one of the electrode, the lead line and the pad portion.

### ADVANTAGEOUS EFFECTS OF INVENTION

The liquid crystal display device and the method of manufacturing the liquid crystal display device according to the present invention allow improvement in the yield.

### BRIEF DESCRIPTION OF DRAWINGS

Fig. 1 is an exploded perspective view showing the configuration of a television receiver 500 according to the first embodiment of the present invention.
Fig. 2 is a perspective view schematically showing a liquid crystal display device 300.
Fig. 3 is a plan view schematically showing a liquid crystal display element 200.
Fig. 4 is an exploded perspective view showing the state where a liquid crystal display panel 101 and a polarization plate 156 are arranged.
Fig. 5 is a plan view of liquid crystal display panel 101.
Fig. 6 is a circuit diagram showing a thin film transistor array formed in an active matrix substrate 130.
Fig. 7 is a cross sectional view of active matrix substrate 130.
Fig. 8 is a cross sectional view of a source pad 114 formed in a peripheral region 105.
Fig. 9 is a schematic plan view partially showing the inside of a pixel array region 107.
Fig. 10 is a cross sectional view schematically showing a portion in which an aluminum alloy material film 136b and a pixel electrode 116 are in contact with each other.
Fig. 11 is a cross sectional view showing the details of a portion in which an ITO film 141 and a gate pad 112 are in contact with each other.
Fig. 12 is a cross sectional view showing the first manufacturing process of the processes of manufacturing liquid crystal display device 300.
Fig. 13 is a cross sectional view of the region having source pad 114 formed therein, in the first manufacturing process of the processes of manufacturing liquid crystal display device 300 shown in Fig. 12.
Fig. 14 is a cross sectional view showing the manufacturing process after the processes of manufacturing liquid crystal display device 300 shown in Figs. 12 and 13.
Fig. 15 is a cross sectional view of source pad 114 in the manufacturing process shown in Fig. 14.
Fig. 16 is a plan view during the manufacturing process shown in Figs. 14 and 15.
Fig. 17 is a cross sectional view showing the manufacturing process after the processes of manufacturing liquid crystal display device 300 shown in Figs. 14 to 16.
Fig. 18 is a cross sectional view of source pad 114 during the manufacturing process shown in Fig. 17.
Fig. 19 is a plan view during the manufacturing process shown in Figs. 17 and 18.
Fig. 20 is a cross sectional view showing the manufacturing process after the manufacturing processes shown in Figs. 17 to 19.
Fig. 21 is a cross sectional view of source pad 114 during the manufacturing process shown in Fig. 20.
Fig. 22 is a plan view during the manufacturing process shown in Figs. 20 and 21.
Fig. 23 is a cross sectional view of active matrix substrate 130 of the liquid crystal display device according to the present second embodiment.
Fig. 24 is a cross sectional view of source pad 114.
Fig. 25 is a cross sectional view showing the first manufacturing process of the processes of manufacturing liquid crystal display device 300 according to the third embodiment of the present invention.
Fig. 26 is a cross sectional view in the region having source pad 114 formed therein.
Fig. 27 is a cross sectional view showing the manufacturing process after the manufacturing process shown in Figs. 25 and 26.
Fig. 28 is a cross sectional view in the region having source pad 114 formed therein.
Fig. 29 is a cross sectional view showing the manufacturing process after the manufacturing process shown in Figs. 27 and 28.
Fig. 30 is a cross sectional view in the region having source pad 114 formed therein during the manufacturing process shown in Fig. 29.
Fig. 31 is a cross sectional view showing the manufacturing process after the manufacturing process shown in Figs. 29 and 30.
Fig. 32 is a cross sectional view in the region having source pad 114 formed therein during the manufacturing process shown in Fig. 31.
Fig. 33 is a cross sectional view of a liquid crystal display device according to the third embodiment of the present invention.
Fig. 34 is a cross sectional view of source pad 114.
Fig. 35 is a cross sectional view showing the first manufacturing process of the processes of manufacturing liquid crystal display device 300 according to the present third embodiment.
Fig. 36 is a cross sectional view of the region having a source pad formed therein during the manufacturing process shown in Fig. 35.
Fig. 37 is a cross sectional view showing the manufacturing process after the manufacturing process shown in Figs. 35 and 36.
Fig. 38 is a cross sectional view of the region having a source pad formed therein during the manufacturing process shown in Fig. 37.
Fig. 39 is a cross sectional view showing the manufacturing process after the manufacturing process shown in Figs. 37 and 38.
Fig. 40 is a cross sectional view of the region having a source pad formed therein during the manufacturing process shown in Fig. 39.
Fig. 41 is a cross sectional view showing the manufacturing process after the manufacturing process shown in Figs. 39 and 40.
Fig. 42 is a cross sectional view of the region having a source pad formed therein during the manufacturing process shown in Fig. 41.
Fig. 43 is a cross sectional view showing the manufacturing process after the manufacturing process shown in Figs. 41 and 42.
Fig. 44 is a cross sectional view of the region having a source pad formed therein during the manufacturing process shown in Fig. 43.

### DESCRIPTION OF EMBODIMENTS

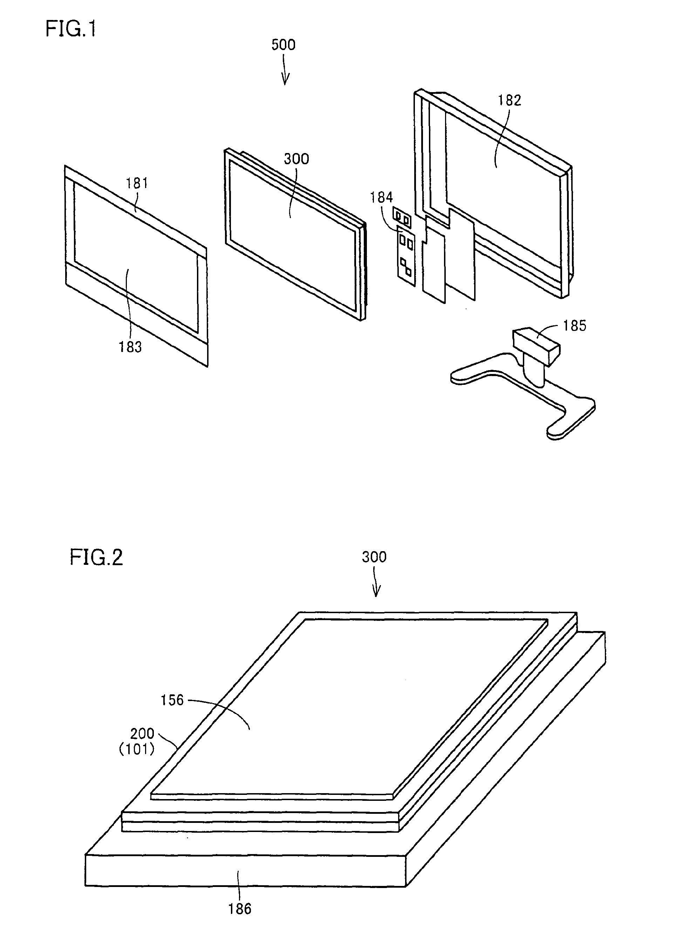

A liquid crystal display device and a method of manufacturing a liquid crystal display device according to the embodiments of the present invention will be hereinafter described with reference to Figs. 1 to 44.

In the embodiments described below, when the number, the quantity and the like are mentioned, the scope of the present invention is not necessarily limited thereto unless otherwise specified. In the following embodiments, each component is not necessarily essential for the present invention unless otherwise specified. Furthermore, when a plurality of embodiments are provided in the following description, it is originally intended to combine characteristic portions in each embodiment as appropriate, unless otherwise specified.

### (First Embodiment)

Fig. 1 is an exploded perspective view showing the configuration of a television receiver 500 according to the first embodiment of the present invention. As shown in this Fig. 1, television receiver 500 includes a casing 181 disposed on the front side, a casing 182 disposed on the back side, a liquid crystal display device 300 disposed between casing 181 and casing 182, an operation circuit 184, and a supporting member 185.

Liquid crystal display device 300 is surrounded by casings 181 and 182, and sandwiched between casings 181 and 182.

Casing 181 is provided with an opening 183, through which the image displayed on liquid crystal display device 300 can be transmitted to the outside. Casing 182 is provided with operation circuit 184 for operating liquid crystal display device 300. Casing 182 is supported by supporting member 185.

Fig. 2 is a perspective view schematically showing liquid crystal display device 300. As shown in this Fig. 2, liquid crystal display device 300 includes a liquid crystal display element 200 having a liquid crystal display panel 101, a polarization plate 156 attached onto one of the main surfaces of liquid crystal display panel 101, a polarization plate attached onto the other of the main surfaces of liquid crystal display panel 101, and a back light unit 186 applying light to liquid crystal display panel 101.

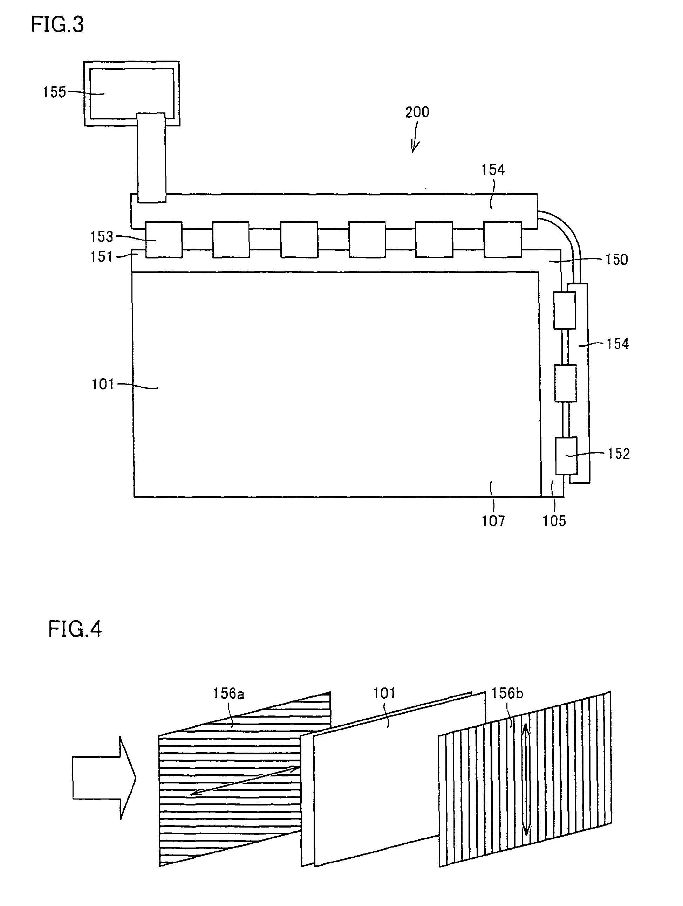

Fig. 3 is a plan view schematically showing liquid crystal display element 200. As shown in this Fig. 3, liquid crystal display element 200 includes liquid crystal display panel 101, a gate driver 152 connected to a gate terminal portion 150 of liquid crystal display panel 101, a source driver 153 connected to a source terminal portion 151 of liquid crystal display panel 101, a printed circuit board wiring 154 to which gate driver 152 and source driver 153 are connected, and a display control circuit 155 to which printed circuit board wiring 154 is connected.

Fig. 4 is an exploded perspective view showing the state where liquid crystal display panel 101 and polarization plate 156 are arranged. As shown in this Fig. 4, liquid crystal display panel 101 has main surfaces, one of which has a polarization plate 156a attached thereto, and the other of which has another polarization plate 156b attached thereto.

In addition, the polarization axis direction of polarization plate 156a is orthogonal to the polarization axis direction of polarization plate 156b. Polarization plate 156a is irradiated with light from back light unit 186 shown in Fig. 2.

Liquid crystal display panel 101 includes an active matrix substrate, an opposing substrate disposed to face this active matrix substrate and spaced apart from this active matrix substrate, and a liquid crystal layer enclosed between the active matrix substrate and the opposing substrate.

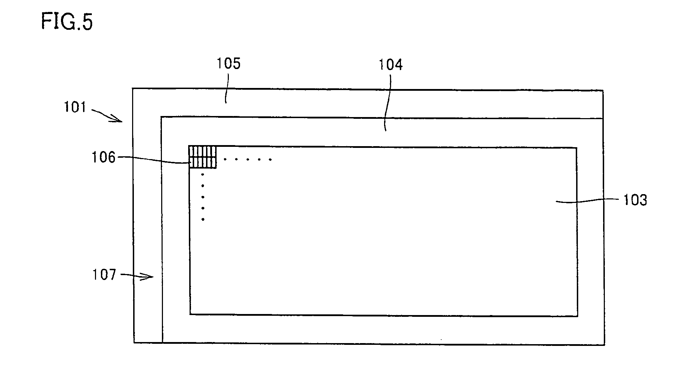

Fig. 5 is a plan view of liquid crystal display panel 101. As shown in this Fig. 5, liquid crystal display panel 101 includes a pixel array region 107 including a display region 103 and a non-display region 104, and a peripheral region 105 located outside of this pixel array region 107.

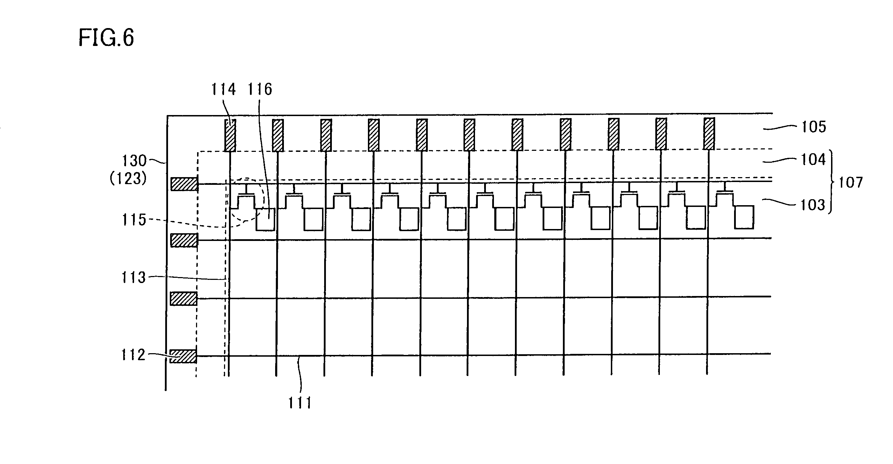

Display region 103 serves as a region displaying an image and is formed of a plurality of pixels. Non-display region 104 does not display an image and is disposed around display region 103. Fig. 6 is a circuit diagram showing a thin film transistor array formed in an active matrix substrate 130.

Active matrix substrate 130 is provided with a transparent substrate 123 including pixel array region 107 and peripheral region 105 located outside of pixel array region 107.

A plurality of thin film transistors (switching elements) 115 are arranged in a portion of the main surface of transparent substrate 123 in which display region 103 of pixel array region 107 is located. A plurality of gate lines 111 each connected to the gate electrode of thin film transistor 115 and a plurality of source lines 113 each connected to the source electrode of thin film transistor 115 are formed in active matrix substrate 130. A pixel electrode 116 is connected to the drain electrode of thin film transistor 115.

Active matrix substrate 130 is generally formed in a rectangular shape. Gate lines 111 extend in the direction of a longer dimension of active matrix substrate 130, and are disposed spaced apart from each other in the direction of a shorter dimension of active matrix substrate 130. Source lines 113 extend in the direction of the shorter dimension of active matrix substrate 130 and are disposed spaced apart from each other in the direction of the longer dimension of active matrix substrate 130.

One pixel electrode 116 is disposed within the region surrounded by gate line 111 and source line 113.

Gate line 111 extends from thin film transistor 115 through pixel array region 107 to peripheral region 105. Also, a gate pad 112 is formed in a portion of gate line 111 located on peripheral region 105.

Source line 113 extends from thin film transistor 115 through pixel array region 107 to peripheral region 105. Also, a source pad 114 is formed in a portion of source line 113 located on peripheral region 105.

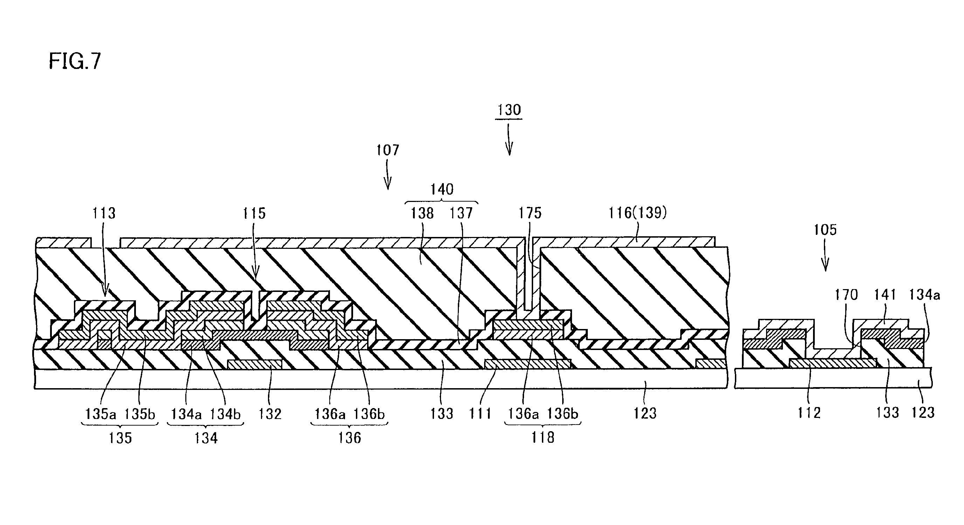

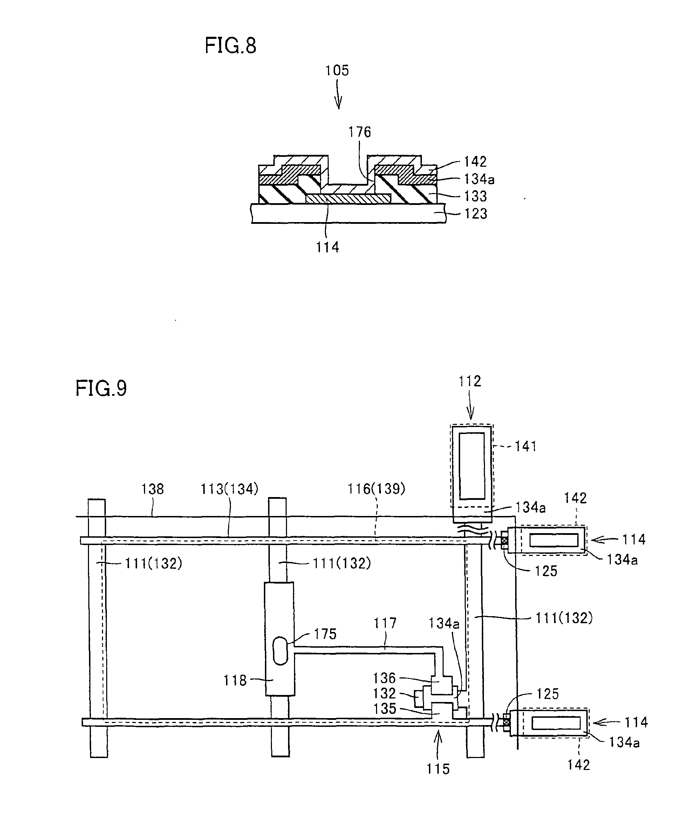

Fig. 7 is a cross sectional view of active matrix substrate 130. In addition, Fig. 7 shows a cross sectional view in display region 103 on the left side of the figure and also shows a cross sectional view of gate pad 112 formed in peripheral region 105 on the right side of the figure. Fig. 8 is a cross sectional view of source pad 114 formed in peripheral region 105. Fig. 9 is a schematic plan view partially showing the inside of pixel array region 107.

As shown in Fig. 7, active matrix substrate 130 includes transparent substrate 123 on which thin film transistor 115 is formed. Active matrix substrate 130 includes a gate electrode 132 located within pixel array region 107 and formed on transparent substrate 123, gate line 111 formed on transparent substrate 123 and connected to gate electrode 132, gate pad 112 located in peripheral region 105 and formed on transparent substrate 123, and gate insulating film 133 formed so as to cover gate electrode 132, gate line 111 and gate pad 112.

Gate electrode 132, gate line 111 and gate pad 112 are integrally formed as shown in Fig. 9. Gate line 111 connects gate electrode 132 and gate pad 112 while gate pad 112 is formed at the end of gate line 111.

In Fig. 7, active matrix substrate 130 includes a semiconductor layer 134 formed on the upper surface of gate insulating film 133 and located above gate electrode 132. a drain electrode (first electrode) 136 formed on this semiconductor layer 134, and a source electrode 135 5 formed on semiconductor layer 134 and spaced apart from drain electrode 136.

Thin film transistor 115 includes gate electrode 132, semiconductor layer 134, and source electrode 135 and drain electrode 136.

Semiconductor layer 134 includes an amorphous silicon film (a-Si film: i layer) 134a formed on gate insulating film 133, and an amorphous silicon film (n+ layer) 134b formed on this amorphous silicon film (i layer) 134a. Amorphous silicon film (i layer) 134a functions as a channel portion of thin film transistor 115.

As shown in Fig. 9, drain electrode 136 has a drain line 117 connected thereto, and this drain line 117 is connected to a drain pad portion 118. Pixel electrode 116 is connected to this drain pad portion 118. Drain electrode 136, drain line 117 and drain pad portion 118 are integrally formed, in which drain electrode 136 and pixel electrode 116 are electrically connected to each other. Pixel electrode 116 is formed of an ITO film.

Source line 113 is connected to source electrode 135. Source line 113 also has an end to which source pad 114 is connected via a contact 125.

Source electrode 135 and source line 113 are formed on gate insulating film 133 while source pad 114 is formed on the main surface of transparent substrate 123.

Contact 125 shown in Fig. 9 is formed so as to pass through gate insulating film 133, and connects the end of source pad 114 and the end of source line 113.

Gate electrode 132, gate line 111, gate pad 112, and source pad 114 each are formed on the main surface of transparent substrate 123, and made of the same first aluminum alloy material film.

Drain electrode 136, drain line 117, drain pad portion 118, source electrode 135, and source line 113 include their respective second aluminum alloy material films 136b, 135b, and their respective metal films 136a, 135a formed below these aluminum alloy material films 136a, 135b.

The first aluminum alloy material film includes aluminum as a base material, an alloy component (first alloy component) containing at least one type of element selected from the group consisting of cobalt (Co), rhodium (Rh), nickel (Ni), palladium (Pd), carbon (C), silicon (Si), germanium (Ge), and tin (Sn), and another component (first another component) containing an element different from aluminum and each element listed above, in which the total number of types of the elements of the alloy component and another component is three or more.

Second aluminum alloy material films 135b and 136b each also include aluminum as a base material, an alloy component (second alloy component) containing at least one type of element selected from the group consisting of cobalt (Co), rhodium (Rh), nickel (Ni), palladium (Pd), carbon (C), silicon (Si), germanium (Ge), and tin (Sn), and another component (second another component) containing an element different from aluminum and each element listed above, in which the total number of types of the elements of the alloy component and another component is three or more.

The first aluminum alloy material film and second aluminum alloy material films 135b, 136b each can be patterned by wet etching and also can suppress generation of dust when forming each line, pad and electrode, so that excellent patterning can be carried out. This allows improvement in the yield of active matrix substrate 130, liquid crystal display device 300, and the like.

The first aluminum alloy material film and second aluminum alloy material films 135b, 136b each include an alloy component containing at least one type of element selected from the group consisting of cobalt (Co), rhodium (Rh), nickel (Ni), palladium (Pd), carbon (C), silicon (Si), germanium (Ge), and tin (Sn), thereby allowing improvement in contact resistance with the transparent conductive film such as an ITO film.

Furthermore, by including another component (the first another component, the second another component) containing an element other than aluminum, cobalt (Co), rhodium (Rh), nickel (Ni), palladium (Pd), carbon (C), silicon (Si), germanium (Ge), and tin (Sn), the sheet resistance can be reduced and the resistance to chemical solution can be enhanced.

Examples of another component may include copper (Cu), lanthanum (La), boron (B), neodymium (Nd), silver (Ag), gold (Au), platinum (Pt), yttrium (Y), niobium (Nb), tungsten (W), and zirconium (Zr).

As shown in Fig. 7, pixel electrode 116 is connected to aluminum alloy material film 136b of drain pad portion 118.

The potential difference between the above-described aluminum alloy material film and the ITO film is approximately 1.0V while the potential difference between aluminum and the ITO film is approximately 1.6V. Accordingly, when comparing the case where the aluminum alloy material film and the ITO film are in contact with each other with the case where aluminum and the ITO film are in contact with each other, the aluminum alloy material film is less likely to corrode. Therefore, pixel electrode 116 and the aluminum alloy material film can be directly connected, as shown also in Fig. 7. Similarly, gate pad 112 formed of an aluminum alloy material film and an ITO film (transparent conductive film) 141 can also be brought into direct contact with each other.

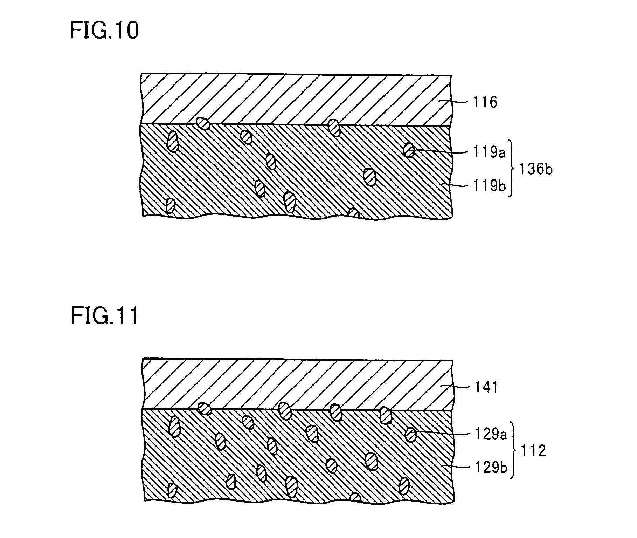

Fig. 10 is a cross sectional view schematically showing a portion in which aluminum alloy material film 136b and pixel electrode 116 are in contact with each other.

As shown in this Fig. 10, aluminum alloy material film 136b includes a base material 119b and a plurality of precipitates 119a.

Precipitates 119a are conductive granular precipitates. Precipitates 119a are distributed from the inside of base material 119b over the surface thereof. Also, precipitates 119a are exposed from the surface of base material 119b in a portion of the surface of second aluminum alloy material film 136b that is in contact with pixel electrode 116.

Then, as these exposed precipitates 119a come into contact with pixel electrode 116, the contact resistance between pixel electrode 116 and second aluminum alloy material film 136b can be suppressed low.

In this case, a precipitate is represented as AlₓR_{y} (X and Y each are a positive integer: R is one of elements including cobalt, rhodium, nickel, palladium, carbon, silicon, germanium, and tin).

For example, when at least Ni (nickel) is contained as an alloy component of aluminum alloy material film 136b, precipitate 119a is Al₃Ni.

Preferably, the alloy component containing at least one type selected from the group consisting of cobalt, rhodium, nickel, palladium, carbon, silicon, germanium, and tin that are included in second aluminum alloy material films 135b and 136b is 0.5 wt% or more. By using such an alloy component, it becomes possible to ensure the resistance to developing solution at the time when second aluminum alloy material films 135b and 136b and the ITO film are stacked, and also possible to suppress occurrence of corrosion in second aluminum alloy material films 135b and 136b. Furthermore, the contact resistance between second aluminum alloy material films 135b, 136b and the ITO film can also be suppressed.

Further preferably, the alloy component containing at least one type of element selected from the group consisting of cobalt, rhodium, nickel, palladium, carbon, silicon, germanium, and tin is 4.5 wt% or less. By using such an aluminum alloy material film, it becomes possible to suppress occurrence of corrosion in second aluminum alloy material films 135b and 136b and also lower the contact resistance between second aluminum alloy material films 135b, 136b and the ITO film.

An example of the aluminum alloy material film may be an Al-Ni-Cu-La alloy material film containing aluminum (Al) as a base material, nickel (Ni) as an alloy component, and copper (Cu) and lanthanum (La) as another components.

Another example may be an Al-Ni-Ge-Nd alloy material film containing aluminum (Al) as a base material, nickel (Ni) and germanium (Ge) as alloy materials, and neodymium (Nd) as another component.

Another example may be an Al-Co-Ge-Nd alloy material film containing aluminum (Al) as a base material, cobalt (Co) and germanium (Ge) as alloy components, and neodymium (Nd) as another component.

Another example of the aluminum alloy material film may be an Al-Ni-B alloy material film containing aluminum (Al) as a base material, nickel (Ni) as an alloy component, and boron (B) as another component.

The above-described aluminum alloy material film includes aluminum as a base material, an alloy component containing at least one type of element selected from the group consisting of cobalt (Co), rhodium (Rh), nickel (Ni), palladium (Pd), carbon (C), silicon (Si), germanium (Ge), and tin (Sn), and another component containing an element different from aluminum and each element listed above. In this case, an "element different from aluminum and each element listed above" is copper (Cu), lanthanum (La), boron (B), neodymium (Nd), silver (Ag), gold (Au), platinum (Pt), yttrium (Y), niobium (Nb), tungsten (W), and zirconium (Zr). According to this aluminum alloy material film, not only the contact resistance with the ITO film and the sheet resistance can be reduced, but also the resistance to chemical solution can be ensured.

Furthermore, copper (Cu), lanthanum (La), boron (B), and neodymium (Nd) are preferably used as an "element different from aluminum and each element listed above".

Furthermore, the Al-Ni-Cu-La alloy material film, the Al-Ni-Ge-Nd alloy material film and the Al-Co-Ge-Nd alloy material film among the above-described aluminum alloy material films each include aluminum as a base material, an alloy component containing at least one type of element selected from the group consisting of cobalt, rhodium, nickel, palladium, carbon, silicon, germanium, and tin, and another component containing an element different from aluminum and each element listed above, in which the total number of types of the elements of the alloy component and another component is three or more.

According to this aluminum alloy material film, not only the contact resistance with the ITO film and the sheet resistance can be reduced, but also the resistance to chemical solution can be ensured.

Furthermore, as a specific example, nickel (Ni) is selected, for example, from the group consisting of cobalt, rhodium, nickel, palladium, carbon, silicon, germanium, and tin. Then, the aluminum alloy material film made of 1.0 wt% of nickel, 0.5 wt% of copper (Cu), 0.3 wt% of lanthanum (La), and aluminum (Al) can be employed as second aluminum alloy material films 135b and 136b. In addition, it is preferable to employ nickel as an alloy component.

Metal films 135a and 136a are formed on the lower surfaces of second aluminum alloy material films 135b and 136b, respectively, and formed between their respective second aluminum alloy material films 135b and 136b and semiconductor layer 134.

Metal films 135a and 136a each are formed of elements greater in density than the element of each synthetic metal of second aluminum alloy material films 135b and 136b and than the element of another component different from aluminum and cobalt, rhodium, nickel, palladium, carbon, silicon, germanium, and tin.

Metal films 135a and 136a are formed of molybdenum (Mo), for example. These metal films 135a and 136a suppress the alloy components contained in second aluminum alloy material films 135b and 136b from reaching semiconductor layer 134 and being distributed into semiconductor layer 134, and also suppress variation in the Vth value and the like of thin film transistor 115.

Also in Fig. 7, active matrix substrate 130 includes ITO film 141 formed on the upper surface of gate pad 112, in which gate pad 112 is in direct contact with ITO film 141.

Fig. 11 is a cross sectional view showing the details of a portion in which ITO film 141 and gate pad 112 are in contact with each other. As shown also in this Fig. 11, gate pad 112 includes a base material 129b and a plurality of precipitates 129a.

Precipitates 129a are conductive granular precipitates. Precipitates 129a are distributed from the inside of base material 129b over the surface of base material 129b.

Also, precipitates 129a are exposed in a portion of the surface of gate pad 112 that is in contact with ITO film 141. Precipitates 129a and ITO film 141 are in contact with each other, thereby allowing reduction in the contact resistance between ITO film 141 and gate pad 112.

Preferably, the alloy component containing at least one type selected from the group consisting of cobalt, rhodium, nickel, palladium, carbon, silicon, germanium, and tin contained in gate pad 112 is 0.5 wt% or more. By employing such an alloy component, it becomes possible to ensure the resistance to the developing solution at the time when gate pad 112 and the ITO film are stacked, so that corrosion occurring in gate pad 112 can be suppressed while the contact resistance between gate pad 112 and the ITO film can also be lowered.

Further preferably, the alloy component containing at least one type of element selected from the group consisting of cobalt, rhodium, nickel, palladium, carbon, silicon, germanium, and tin is 0.5 wt% or more and 4.5 wt% or less. By employing such an aluminum alloy material film, it becomes possible to suppress occurrence of corrosion in gate pad 112 and also lower the contact resistance between gate pad 112 and the ITO film.

As a specific example, nickel is selected, for example, from the group consisting of cobalt, rhodium, nickel, palladium, carbon, silicon, germanium, and tin. Then, the aluminum alloy formed of 1.0 wt% of nickel (Ni), 0.5 wt% of copper (Cu), 0.3 wt% of lanthanum (La), and aluminum (Al) can be employed as gate pad 112. In this example, nickel is employed as an alloy component of the aluminum alloy material while copper and lanthanum are employed as another component.

In this case, the distribution density of precipitates 129a formed within the first aluminum alloy material film forming gate pad 112 and source pad 114 is higher than the distribution density of precipitates 119a formed within second aluminum alloy material film 136b.

Accordingly, the area of precipitates 129a exposed from base material 129b per unit area in the interface between ITO film 141 and gate pad 112 is greater than the area of precipitates 119a exposed from base material 119b per unit area in the interface between pixel electrode 116 and second aluminum alloy material film 136b.

In Fig. 7, within pixel array region 107, active matrix substrate 130 includes an interlayer insulating film 140 formed so as to cover source electrode 135, drain electrode 136 and drain pad portion 118.

Interlayer insulating film 140 includes a passivation film 137 formed on gate insulating film 133 so as to cover source electrode 135, drain electrode 136 and drain pad portion 118, and a planarizing film 138 formed on this passivation film 137.

Passivation film 137 is formed of a silicon nitride film and, for example, formed at about 250 degrees by the CVD method. In addition, passivation film 137 and gate insulating film 133 each are formed of a silicon nitride film, in which case the tissue of gate insulating film 133 is more finely structured than that of passivation film 137. Planarizing film 138 is formed of organic material such as an acrylic-based synthetic resin.

Interlayer insulating film 140 is provided with a contact hole 175 formed so as to reach drain pad portion 118. Pixel electrode 116 is formed so as to extend from above the upper surface of planarizing film 138 along the inner peripheral surface of contact hole 175 to reach the upper surface of aluminum alloy material film 136b.

Active matrix substrate 130 includes gate pad 112 formed in peripheral region 105 and ITO film 141 formed on the upper surface of this gate pad 112.

Gate insulating film 133 and an amorphous silicon film (i layer) 134a formed on this gate insulating film 133 are formed in the surrounding area of gate pad 112. Gate insulating film 133 and amorphous silicon film (i layer) 134a each are provided with a contact hole 170 that reaches the upper surface of gate pad 112. ITO film 141 is formed so as to extend from the upper surface of amorphous silicon film (i layer) 134a along the inner peripheral surface of contact hole 170 to reach the upper surface of gate pad 112.

In Fig. 8, gate insulating film 133 and amorphous silicon film (i layer) 134a formed on this gate insulating film 133 are formed in the surrounding area of source pad 114. Gate insulating film 133 and amorphous silicon film (i layer) 134a each are provided with a contact hole 176 that reaches the upper surface of source pad 114. ITO film 141 is formed so as to extend from the upper surface of amorphous silicon film (i layer) 134a along the inner peripheral surface of contact hole 176 to reach the upper surface of source pad 114.

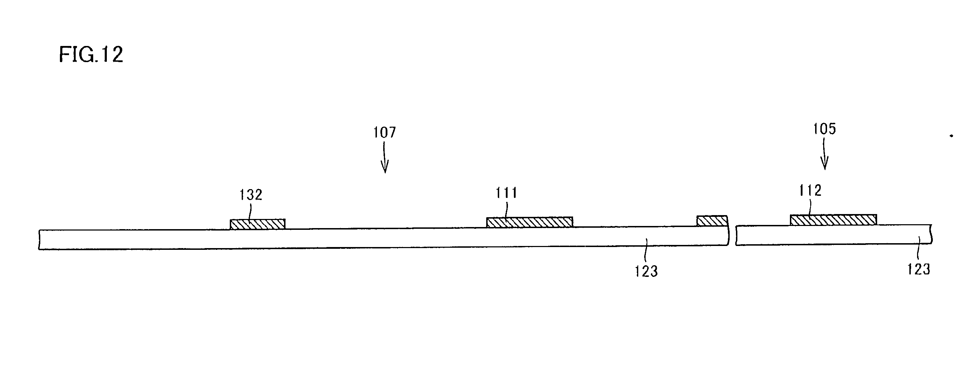

The method of manufacturing liquid crystal display device 300 according to the first embodiment of the present invention will be hereinafter described with reference to Figs. 12 to 22.

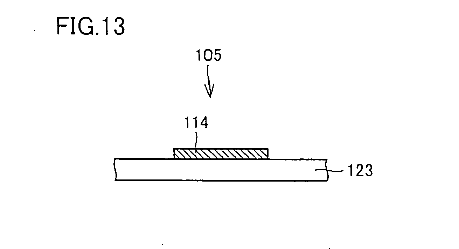

Fig. 12 is a cross sectional view showing the first manufacturing process of the processes of manufacturing liquid crystal display device 300. Fig. 13 is a cross sectional view of the region having source pad 114 formed therein, in the first manufacturing process of the processes of manufacturing liquid crystal display device 300 shown in Fig. 12.

As shown in Figs. 12 and 13, an aluminum alloy material film is formed on the main surface of transparent substrate 123, for example, using the sputtering vapor deposition method.

Then, the formed aluminum alloy material film is patterned to form gate electrode 132, gate line 111, gate pad 112, and source pad 114 on the main surface of transparent substrate 123. As described above, the aluminum alloy material film can be patterned by wet etching, so that gate line 111, gate pad 112, gate electrode 132, and source pad 114 can be excellently formed.

It is to be noted that gate line 111, gate pad 112, gate electrode 132, and source pad 114 each have a thickness of about 2000Å, for example.

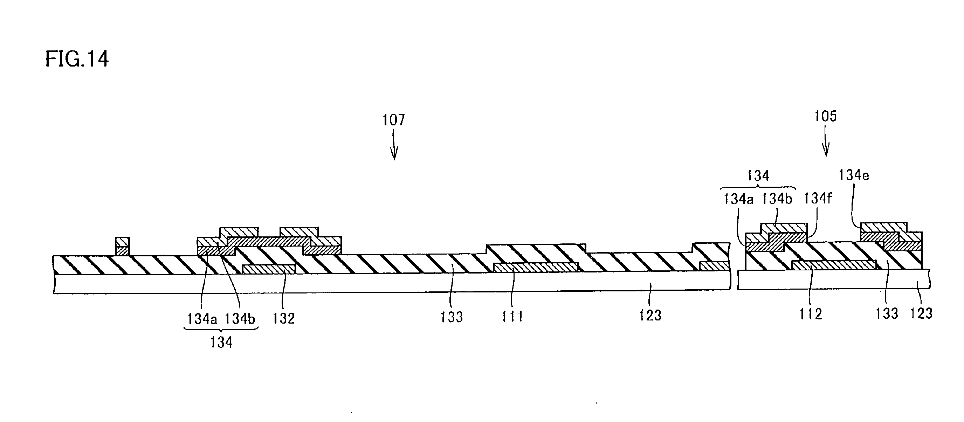

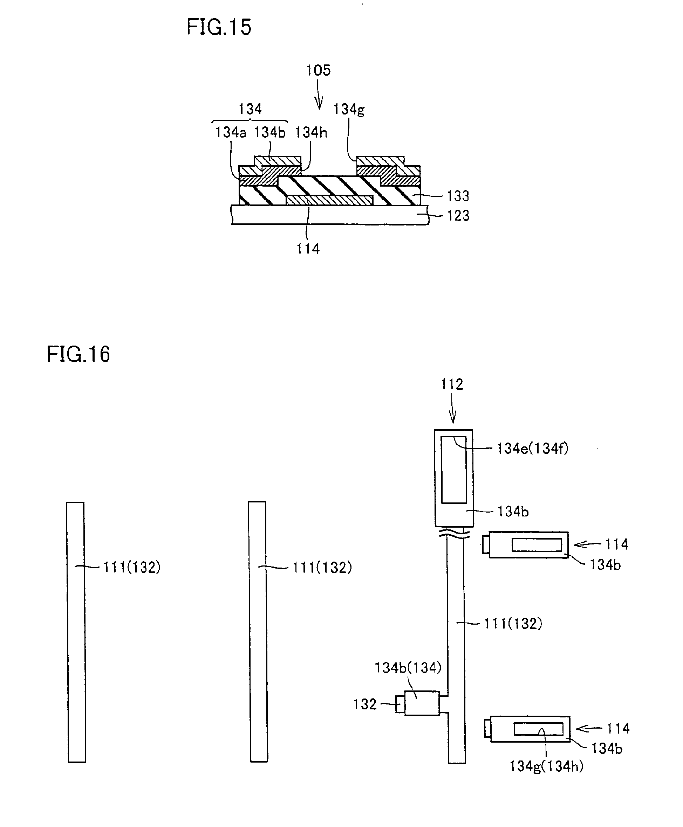

Fig. 14 is a cross sectional view showing the manufacturing process after the process of manufacturing liquid crystal display device 300 shown in Figs. 12 and 13 described above. Fig. 15 is a cross sectional view of source pad 114 in the manufacturing process shown in Fig. 14.

As shown in these Figs. 14 and 15, gate insulating film 133 is formed on the main surface of transparent substrate 123 so as to cover gate electrode 132, gate line 111, gate pad 112, and source pad 114.

Gate insulating film 133 is, for example, formed by the CVD method, in which case the film forming temperature is approximately 350 °C, for example.

When forming gate insulating film 133, the temperature within the chamber is increased, thereby increasing the temperature of each of gate electrode 132, gate line 111, gate pad 112, and source pad 114 which are already formed therein. Then, gate electrode 132, gate line 111, gate pad 112, and source pad 114 are cooled, thereby causing conductive precipitates to settle within gate electrode 132, gate line 111, gate pad 112, and source pad 114. The precipitate is represented as AlₓR_{y} (X and Y each are a positive integer: R is one of Co, Rh, Ni, Pd, C, Si, Ge and Sn).

It is to be noted that gate insulating film 133 is formed of a silicon nitride film and has a film thickness of approximately 4100Å, for example.

After forming gate insulating film 133, an amorphous silicon film (i layer) and an amorphous silicon film (n+ layer) are sequentially formed on the upper surface of gate insulating film 133 by the CVD method. Then, the amorphous silicon film (i layer) and the amorphous silicon film (n+ layer) are patterned. Consequently, semiconductor layer 134 including amorphous silicon film (i layer) 134a and an amorphous silicon film (n+ layer) 134b is formed.

Amorphous silicon film (i layer) 134a has a film thickness of_{;} for example, about 1750Å while amorphous silicon film (n+ layer) 134b has a film thickness of, for example, about 550Å.

Amorphous silicon film (i layer) 134a remains in each portion of the upper surface of gate insulating film 133 that is located above gate electrode 132 and located above gate pad 112.

Amorphous silicon film (i layer) 134a formed above gate electrode 132 is patterned so as to cover gate electrode 132. On the upper surface of this amorphous silicon film (i layer) 134a, amorphous silicon film (n+ layer) 134b is formed spaced apart therefrom.

Amorphous silicon film (i layer) 134a formed above gate pad 112 is provided with a hole 134f. Amorphous silicon film (n+ layer) 134b is formed on the upper surface of amorphous silicon film (i layer) 134a formed above this gate pad 112. This amorphous silicon film (n+ layer) 134b is also provided with a hole 134e in communication with hole 134f.

Then, the upper surface of gate insulating film 133 located above gate pad 112 is exposed through hole 134e and hole 134f to the outside.

Amorphous silicon film (i layer) 134a formed above source pad 114 is provided with a hole 134h. Amorphous silicon film (n+ layer) 134b is formed on the upper surface of amorphous silicon film (i layer) 134a formed above this source pad 114. This amorphous silicon film (n+ layer) 134b is also provided with a hole 134g in communication with hole 134h.

Then, the upper surface of gate insulating film 133 located above source pad 114 is exposed through hole 134h and hole 134g to the outside.

Fig. 16 is a plan view during the manufacturing process shown in Figs. 14 and 15 described above. As shown in this Fig. 16, a plurality of gate lines 111 extending in one direction are formed spaced apart from each other on the main surface of transparent substrate 123. Also, gate pad 112 is formed at the end of each gate line 111. Furthermore, a plurality of source pads 114 are formed on the main surface of transparent substrate 123 that are spaced apart from each other in the direction in which gate lines 111 extend.

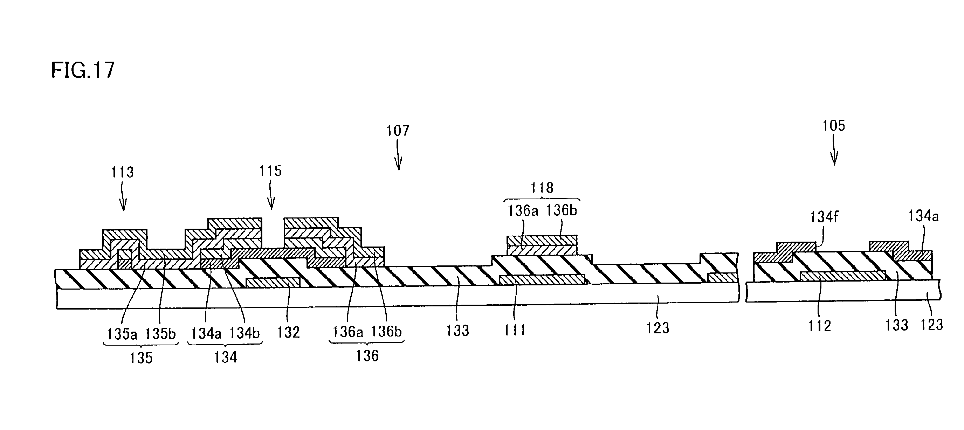

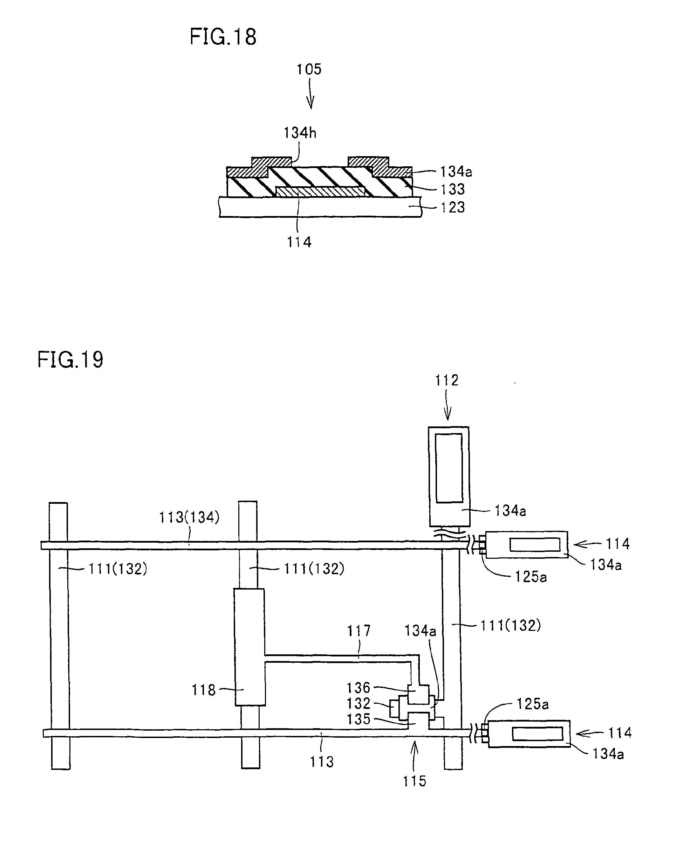

Fig. 17 is a cross sectional view showing the manufacturing process after the process of manufacturing liquid crystal display device 300 shown in Figs. 14 to 16 described above. Fig. 18 is a cross sectional view of source pad 114 during the manufacturing process shown in Fig. 17.

In Figs. 17 and 18, for example, metal film 136a formed of molybdenum (Mo) and second aluminum alloy material film 136b are sequentially formed.

Then, these stacked metal film 135a and second aluminum alloy material film 136b are patterned using a mask. In this case, metal film 135a and second aluminum alloy material film 136b can be patterned by wet etching while source electrode 135 and drain electrode 136 can be excellently patterned.

Thus, after forming source electrode 135 and drain electrode 136, amorphous silicon film (n+ layer) 134b located on gate electrode 132 and source pad 114 are also removed.

Fig. 19 is a plan view during the manufacturing process shown in Figs. 17 and 18. As shown in this Fig. 19, metal film 135a and second aluminum alloy material film 136b are patterned to thereby form source line 113, drain pad portion 118, drain line 117, drain electrode 136, and source electrode 135.

Furthermore, a contact hole 125a is formed at the end of source line 113 located above the end of first aluminum alloy material film forming source pad 114.

This contact hole 125a passes through gate insulating film 133 located between source line 113 and source pad 114. Consequently, the upper surface of the first aluminum alloy material film forming source pad 114 is exposed from the bottom of contact hole 125a.

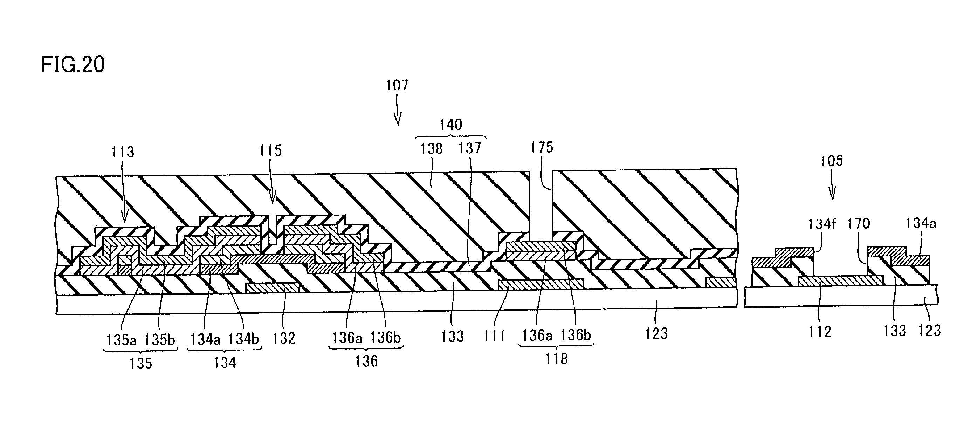

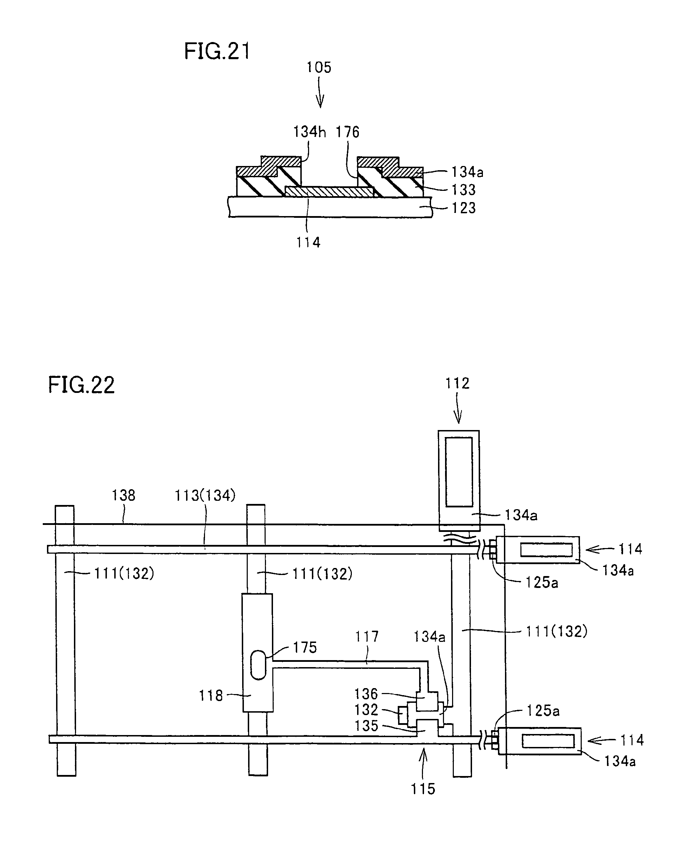

Fig. 20 is a cross sectional view showing the manufacturing process after the manufacturing process shown in Figs. 17 to 19 described above. Fig. 21 is a cross sectional view of source pad 114 during the manufacturing process shown in Fig. 20.

In these Figs. 20 and 21, passivation film 137 serving as a silicon nitride film is first formed using the CVD method. The film forming temperature in this case is approximately 250 degrees, for example.

Passivation film 137 is formed so as to cover second aluminum alloy material films 135b, 136b and gate insulating film 133.

Second aluminum alloy material film 135b is also heated by the heat at the time when passivation film 137 is formed. This leads to formation of precipitates within second aluminum alloy material film 135b.

It is to be noted that the film forming temperature of passivation film 137 is lower than the film forming temperature of gate insulating film 133. Accordingly, the precipitation density of the precipitates settling within second aluminum alloy material films 135b, 136b is lower than the precipitation density of the precipitates settling within the first aluminum alloy material film forming gate line 111 and the like. In addition, the precipitation density indicates a volume of the precipitates settling in a unit volume.

After forming passivation film 137, planarizing film 138 is formed. Planarizing film 138 is formed of an acrylic-based organic material, for example. This planarizing film 138 is patterned to remove the portion located on peripheral region 105. Consequently, planarizing film 138 located on source pad 114 and gate pad 112 is removed. Furthermore, during this patterning, planarizing film 138 is patterned to provide a contact hole.

This patterned planarizing film 138 is used as a mask to pattern passivation film 137 and the like.

Accordingly, in display region 103, passivation film 137 located on drain pad portion 118 is patterned to expose a part of the upper surface of drain pad portion 118, as shown in Fig. 20.

Also as shown in Fig. 20, in peripheral region 105, gate insulating film 133 is patterned using amorphous silicon film (i layer) 134a as a mask, to form contact hole 170. As shown in Fig. 21, gate insulating film 133 formed on source pad 114 is patterned using amorphous silicon film (i layer) 134a as a mask. Consequently, contact hole 176 is formed to expose a part of the upper surface of source pad 114. In addition, gate insulating film 133 and passivation film 137 each are formed of a silicon nitride film.

Then, the upper surface of second aluminum alloy material film 135b exposed through contact hole 175, the upper surface of gate pad 112 and the upper surface of source pad 114 are subjected to surface treatment with alkaline solution.

This surface treatment causes the precipitates to be exposed from the upper surface of each of second aluminum alloy material film 135b, source pad 114 and gate pad 112.

Fig. 22 is a plan view during the manufacturing process shown in Figs. 20 and 21 described above. As shown in this Fig. 22, the end of source pad 114 on the display region 103 side is covered by planarizing film 138 and passivation film 137.

Then, planarizing film 138 and passivation film 137 are provided with contact hole 125a that reaches the end of source pad 114.

As shown in Figs. 7 and 8, an ITO film is formed on planarizing film 138 and amorphous silicon film (i layer) 134a. Then, this ITO film is patterned to form pixel electrode 116, ITO film 141 and an ITO film (transparent conductive film) 142.

In addition, as shown in Fig. 9, the ITO film formed within contact hole 125a leads to electrical connection between source pad 114 and source line 113. Thus, liquid crystal display device 300 of the liquid crystal display device according to the present embodiment can be manufactured.

### (Second Embodiment)

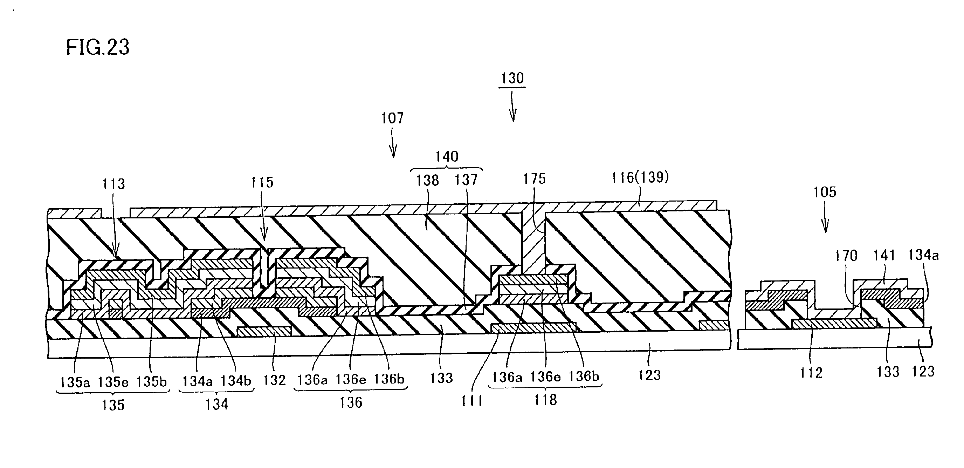

Liquid crystal display device 300 according to the second embodiment of the present invention will be hereinafter described with reference to Figs. 23 to 32. Any of the configurations shown in Figs. 23 to 32 that are identical or correspond to those shown in Figs. 1 to 22 are designated by the same reference characters and description thereof not be repeated.

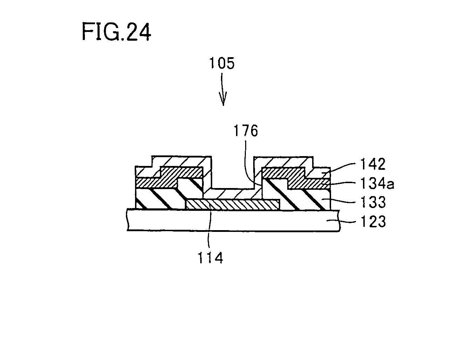

Fig. 23 is a cross sectional view of active matrix substrate 130 of the liquid crystal display device according to the present second embodiment. Fig. 24 is a cross sectional view of source pad 114.

As shown in this Fig. 23, source electrode 135 is formed on semiconductor layer 134 and gate insulating film 133, and includes a metal film 135a formed of molybdenum (Mo), a metal film (intermediate film) 135e formed on metal film 135a and formed of aluminum (Al), and second aluminum alloy material film 135b formed on this metal film 135e.

Similarly, drain electrode 136 includes metal film 136a formed on semiconductor layer 134 and gate insulating film 133, a metal film 136e formed on the upper surface of this metal film 136a, and second aluminum alloy material film 136b formed on the upper surface of this metal film 136e.

In this way, source electrode 135, drain electrode 136, drain pad portion 118 and the like each include a metal film that is formed of Al and disposed between the aluminum alloy material film and the metal film functioning as a diffusion preventing film.

Thus, by including the metal film formed of Al, the electrical resistance can be reduced while the manufacturing cost can be lowered.

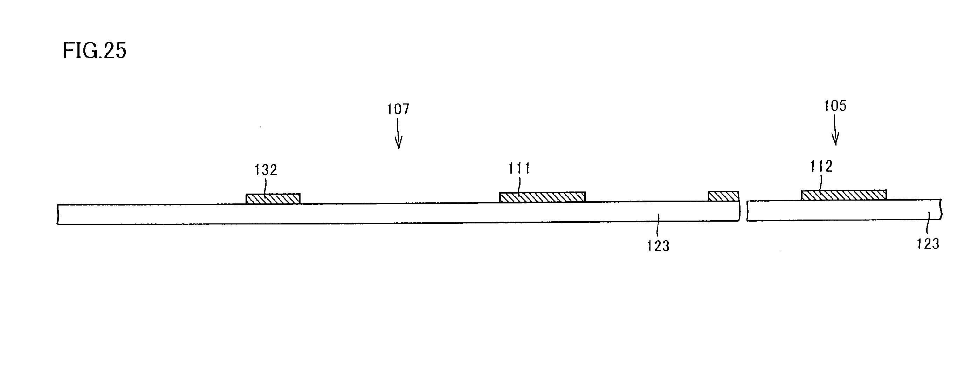

The method of manufacturing liquid crystal display device 300 according to the second embodiment of the present invention will be hereinafter described with reference to Figs. 25 to 32.

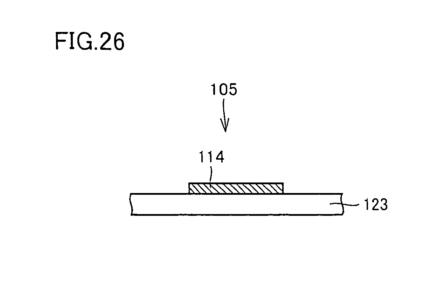

Fig. 25 is a cross sectional view showing the first manufacturing process of the processes of manufacturing liquid crystal display device 300 according to the third embodiment of the present invention. Fig. 26 is a cross sectional view in the region having source pad 114 formed therein.

As shown in Figs. 25 and 26 and as described in the above first embodiment, the first aluminum metal material film is formed and patterned by wet etching, thereby forming gate electrode 132, gate line 111, gate pad 112, and source pad 114.

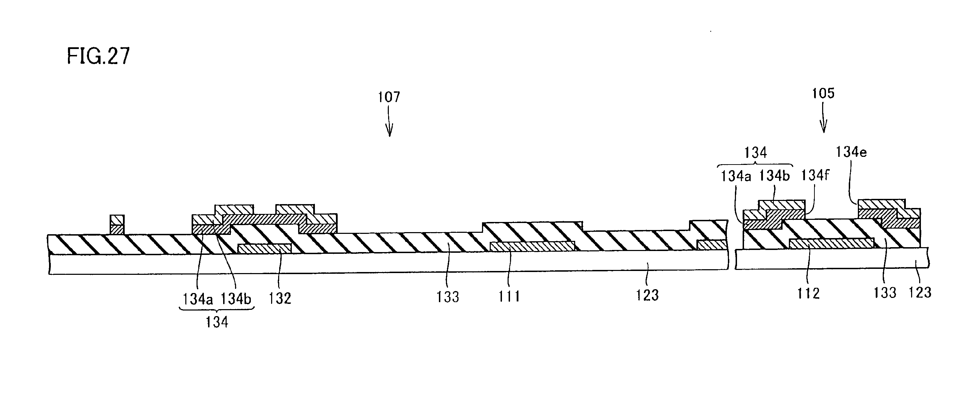

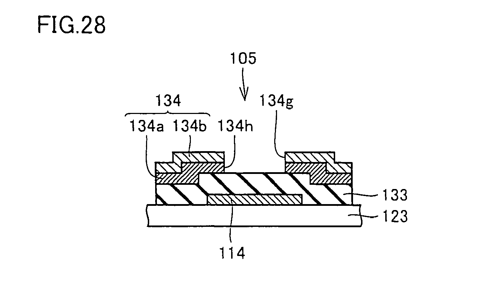

Fig. 27 is a cross sectional view showing the manufacturing process after the manufacturing process shown in Figs. 25 and 26 described above. Fig. 28 is a cross sectional view in the region having source pad 114 formed therein.

As shown in these Figs. 27 and 28, semiconductor layer 134 is formed on each of gate electrode 132, gate pad 112 and source pad 114.

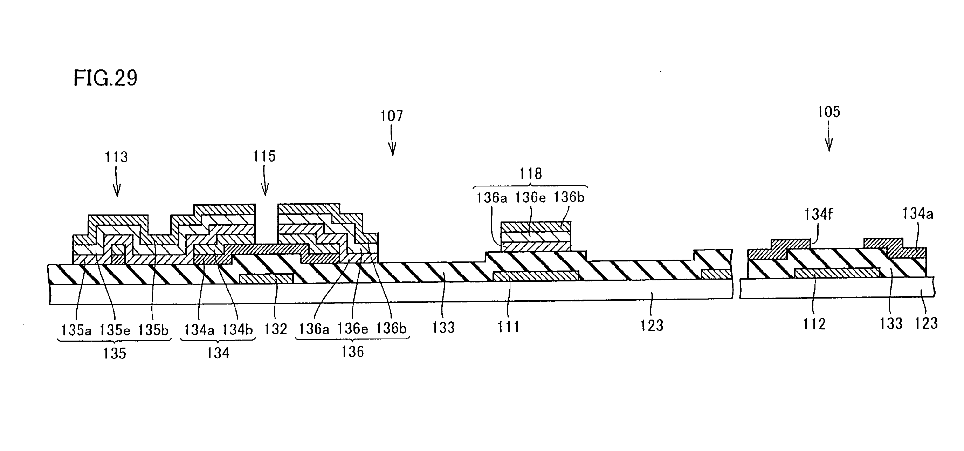

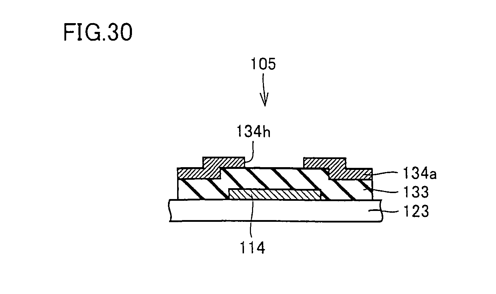

Fig. 29 is a cross sectional view showing the manufacturing process after the manufacturing process shown in Figs. 27 and 28 described above. Fig. 30 is a cross sectional view in the region having source pad 114 formed therein during the manufacturing process shown in Fig. 29.

As shown in these Figs. 29 and 30, the metal film formed of molybdenum (Mo), the metal film formed of aluminum (Al), and the above-described second aluminum alloy material film are sequentially formed. Then, these stacked metal films are patterned by wet etching, to form source electrode 135, drain electrode 136 and drain pad portion 118.

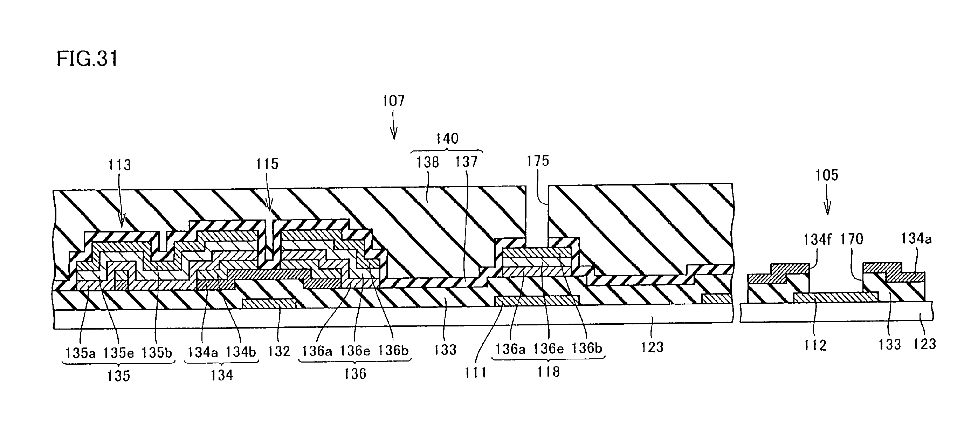

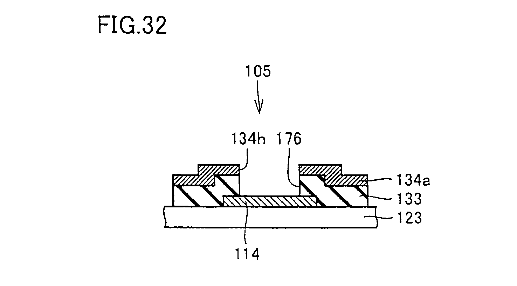

Fig. 31 is a cross sectional view showing the manufacturing process after the manufacturing process shown in Figs. 29 and 30. Fig. 32 is a cross sectional view in the region having source pad 114.formed therein during the manufacturing process shown in Fig. 31.

As shown in these Figs. 31 and 32, planarizing film 138 and passivation film 137 are formed.

Then, an ITO film is formed on planarizing film 138 and then patterned to form pixel electrode 116 and the like.

### (Third Embodiment)

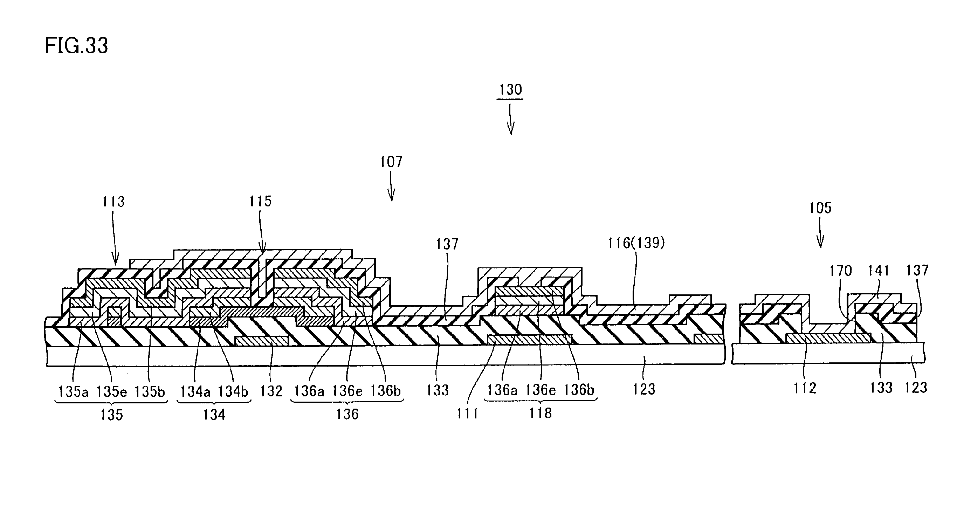

Liquid crystal display device 300 according to the third embodiment of the present invention will be hereinafter described with reference to Figs 33 to 44. In addition, any of the configurations shown in Figs. 33 to 44 that are identical or correspond to those shown in Figs. 1 to 32 described above will be designated by the same reference characters, and description thereof will not be repeated.

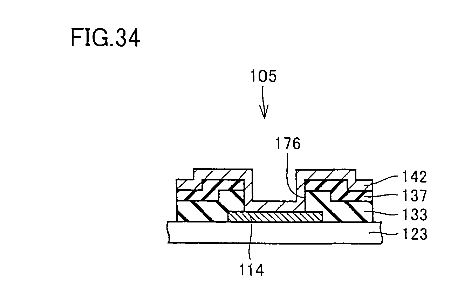

Fig. 33 is a cross sectional view showing the liquid crystal display device according to the third embodiment of the present invention. Fig. 34 is a cross sectional view of source pad 114.

As shown in these Figs. 33 and 34, pixel electrode 116 is formed on the upper surface of passivation film 137. Furthermore, gate insulating film 133 is formed in the peripheral edge of gate pad 112, and passivation film 137 is formed on this gate insulating film 133. Also, gate insulating film 133 and passivation film 137 are provided with contact hole 170 through which a part of the upper surface of gate pad 112 is exposed.

Furthermore, ITO film (transparent conductive film) 141 is formed to extend from the upper surface of passivation film 137 along the inner peripheral surface of contact hole 170 to reach the upper surface of gate pad 112.

In Fig. 34, gate insulating film 133 is formed in the peripheral edge of source pad 114, and passivation film 137 is formed on the upper surface of this gate insulating film 133. Furthermore, gate insulating film 133 and passivation film 137 are provided with contact hole 176 passing through gate insulating film 133 and passivation film 137 and reaching the upper surface of source pad 114. Furthermore, ITO film 142 is formed to extend from the upper surface of passivation film 137 along the inner peripheral surface of contact hole 176 to reach the upper surface of source pad 114.

In this way, in liquid crystal display device 300 according to the present third embodiment, planarizing film 138 is not formed, but pixel electrode 116 and ITO films 141, 142 are formed on passivation film 137.

Also in liquid crystal display device 300 according to the present third embodiment, gate line 111, gate pad 112 and source pad 114 are formed of the first aluminum alloy material film as in the above-described first and second embodiments. Furthermore, second aluminum alloy material films 136b and 135b each are also formed of the aluminum alloy material similar to that in the above-described first and second embodiments.

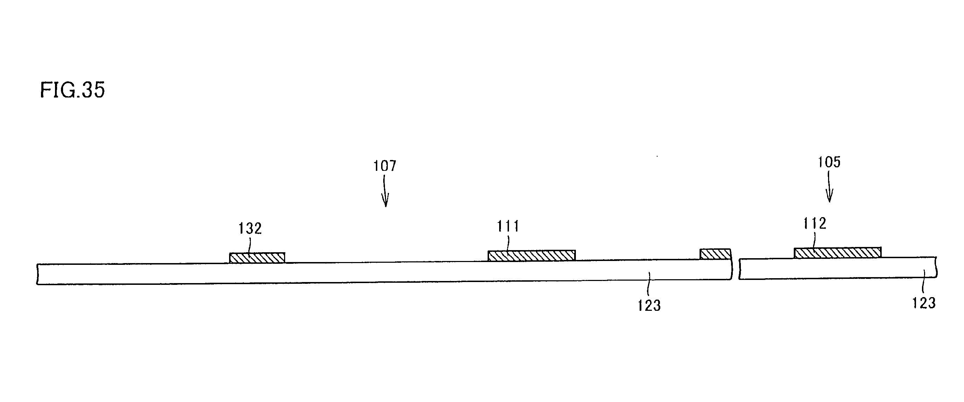

The method of manufacturing liquid crystal display device 300 configured as set forth above will be hereinafter described with reference to Figs. 35 to 44.

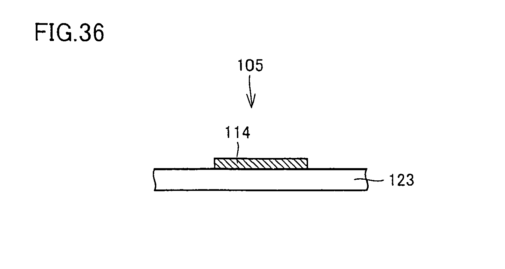

Fig. 35 is a cross sectional view showing the first manufacturing process of the processes of manufacturing liquid crystal display device 300 according to the present third embodiment. Fig. 36 is a cross sectional view of the region having a source pad formed therein during the manufacturing process shown in Fig. 35 described above.

As shown in these Figs. 35 and 36, an aluminum alloy material film is formed on the main surface of transparent substrate 123, and then patterned by wet etching. Consequently, gate line 111, gate pad 112, source pad 114, and gate electrode 132 are formed on the main surface of transparent substrate 123.

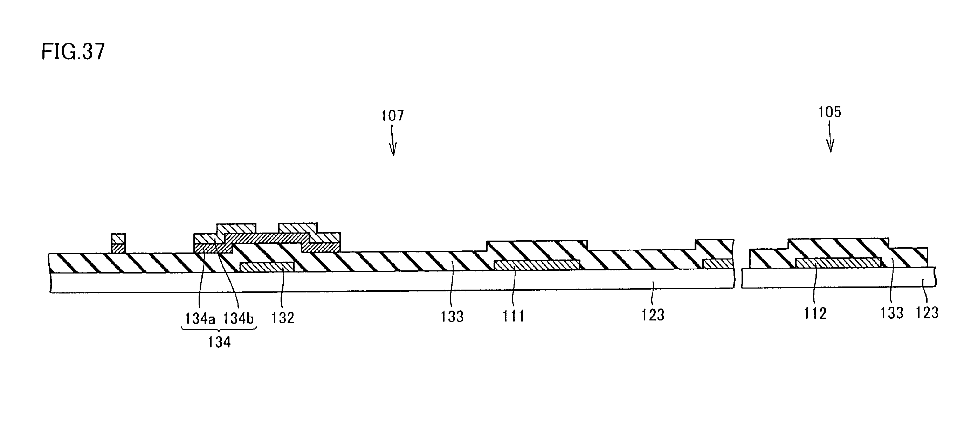

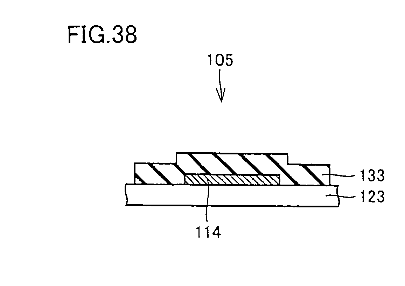

Then, as shown in Figs. 37 and 38, gate insulating film 133 is formed on the main surface of transparent substrate 123 so as to cover gate line 111, gate pad 112, source pad 114, and gate electrode 132. Then, amorphous silicon film (i layer) 134a and amorphous silicon film (n+ layer) 134b are stacked, which are then subjected to patterning.

Consequently, amorphous silicon film (i layer) 134a and amorphous silicon film (n+ layer) 134b located above gate pad 112 and source pad 114 are removed.

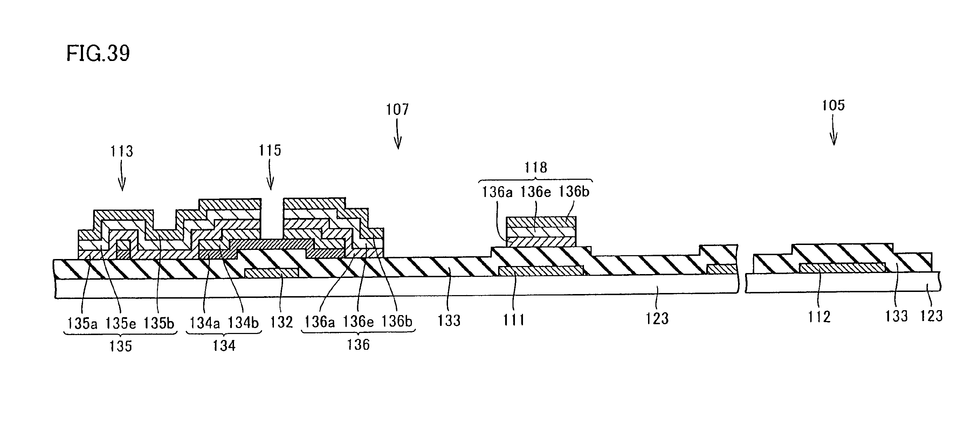

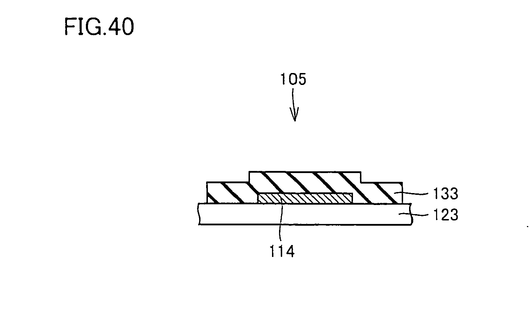

Then, as shown in Figs. 39 and 40, the metal film formed of molybdenum (Mo), the metal film formed of aluminum (Al), and the above-described second aluminum alloy material film are sequentially formed. Then, these stacked metal films are patterned by wet etching. Consequently, each of the metal films located above gate pad 112 and source pad 114 is removed.

Thus, drain pad 118, drain electrode 136 and source electrode 135 are formed.

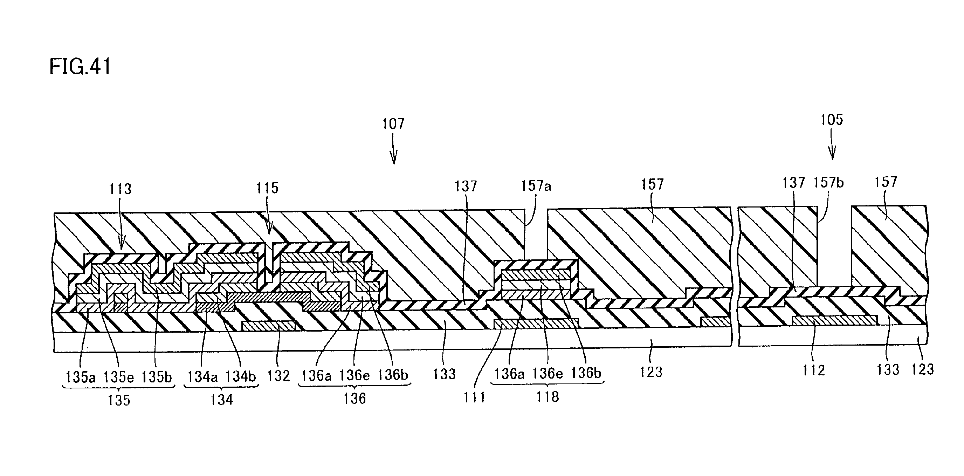

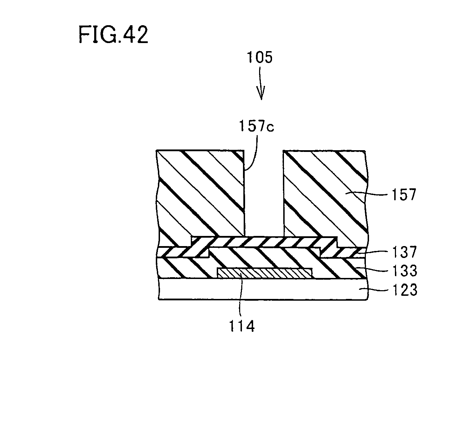

Then, as shown in Figs. 41 and 42, passivation film 137 is formed. A resist film 157 is formed on this passivation film 137. Resist film 157 is then patterned to form holes 157a, 157b and 157c. Hole 157a is located above drain pad 118 while hole 157b is located above gate pad 112. Furthermore, hole 157c is located above source pad 114.

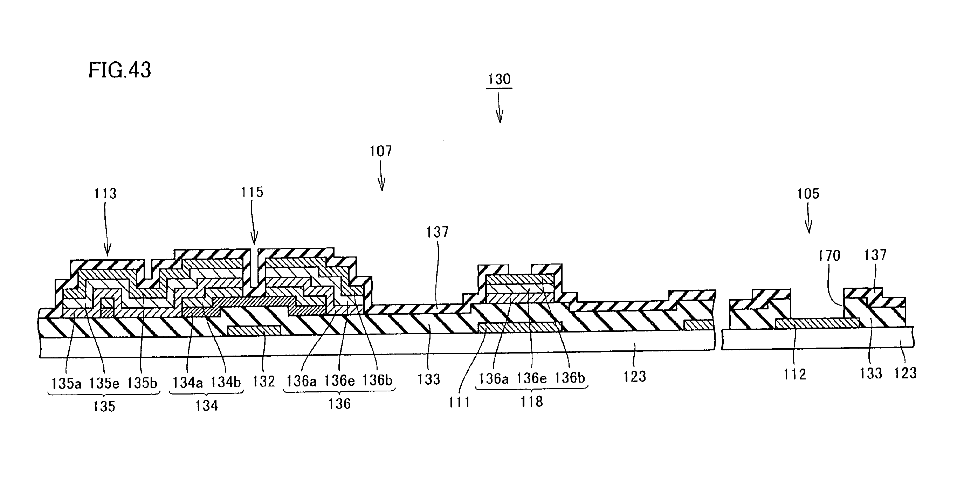

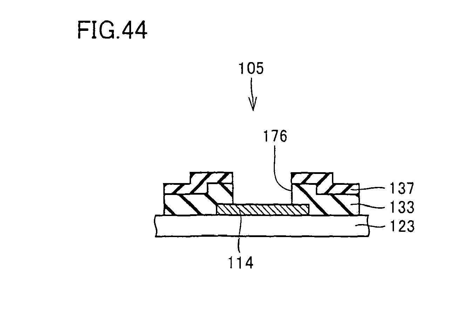

Then, as shown in Figs. 43 and 44, passivation film 137 and gate insulating film 133 are patterned by using, as a mask, resist film 157 having each hole formed therein.

Consequently, a part of the upper surface of drain pad 118 is exposed while a part of the upper surface of gate pad 112 is exposed. Furthermore, a part of the upper surface of source pad 114 is exposed. Resist film 157 is then removed.

Then, surface treatment is applied using an alkaline solution to the upper surface of second aluminum alloy material film 136b, the upper surface of gate pad 112 and the upper surface of source pad 114.

Subsequently, an ITO film 139 is formed and then patterned to form pixel electrode 116, ITO film 141 and ITO film 142. Thus, liquid crystal display device 300 according to the present third embodiment can be manufactured.

Although an explanation has been made in the above-described first to third embodiments with regard to liquid crystal display device 300 having thin film transistor 115 including an amorphous silicon (a-Si) film, the present invention is not limited thereto. For example, the present invention is also applicable to liquid crystal display device 300 employing a low-temperature polysilicon TFT using low temperature polysilicon (p-Si). Furthermore, an oxide semiconductor may be employed in place of thin film transistor 115.

### Example 1

Table I described below shows the results of evaluation about the resistance to the developing solution for a stack of the ITO film and the aluminum alloy material film (the aluminum alloy material film on the ITO film) that has varied wt% of alloy component containing at least one type selected from the group consisting of Co, Rh, Ni, Pd, C, Si, Ge, and Sn. In Table 1 described below, "B" means that corrosion occurred, and "A" means that corrosion did not occur.

Also, Table 2 described below shows a graph about the evaluation of the contact resistance for a stack of the aluminum alloy material film and the ITO film. In Table 2 described below, "A" means that the contact resistance is 100Ω or less. It is to be noted that the contact resistance between pure aluminum and the ITO film is 100Ω.

**[Table 1]**

| <Al Alloy/ITO Structure> | | | | | | |
|---|---|---|---|---|---|---|
| Evaluation for Resistance to Developing Solution | | | | | | |
| | Wt% of Alloy Component | | | | | |
| | 0.2 wt% | 0.5 wt% | 0.7 wt% | 1.0 wt% | 3.2 wt% | 4.5 wt% |
| Determination | B | A | A | A | A | A |

| | | | | | | |
|---|---|---|---|---|---|---|
| B: Corrosion occurred, A: Corrosion did not occur | | | | | | |

**[Table 2]**

| <ITO/Al Alloy Structure> | | | | | | |
|---|---|---|---|---|---|---|
| Evaluation for Contact Resistance | | | | | | |
| | Total Component of the Group Described Above | | | | | |
| | (Co, Rh, Ni, Pd, C, Si, Ge, and Sn) | | | | | |
| | 0.2 wt% | 0.5 wt% | 0.7 wt% | 1.0 wt% | 3.2 wt% | 4.5 wt% |
| Determination | A | A | A | A | A | A |

| | | | | | | |
|---|---|---|---|---|---|---|
| B: 100Ω or more (pure Al), A: 100Ω or less | | | | | | |

As shown in Table 1 described above, it is recognized that the resistance to developing solution can be ensured in the case where the alloy component containing at least one type selected from the group consisting of Co, Rh, Ni, Pd, C, Si, Ge, and Sn is 0.5 wt% or more. Furthermore, it is also recognized that the resistance to developing solution can be ensured by employing the aluminum alloy material film including 0.5 wt% or more and 4.5 wt% or less of the alloy component containing at least one type selected from the group consisting of Co, Rh, Ni, Pd, C, Si, Ge, and Sn.

Furthermore, as shown in Table 2 described above, it is recognized that, by employing the aluminum alloy film including 0.2 wt% or more of the alloy component containing at least one type selected from the group consisting of Co, Rh, Ni, Pd, C, Si, Ge, and Sn, the contact resistance can be suppressed as compared with the case where pure aluminum is employed.

Also, by employing the aluminum alloy material film including 0.5 wt% or more and 4.5 wt% or less of the alloy component containing at least one type selected from the group consisting of Co, Rh, Ni, Pd, C, Si, Ge, and Sn, the contact resistance can be suppressed as compared with the case where pure aluminum is employed.

Thus, as shown in Tables 1 and 2 described above, it is recognized that the resistance to developing solution can be ensured while the contact resistance can be reduced by employing the aluminum alloy material film including 0.5 wt% or more and 4.5 wt% or less of the alloy component containing at least one type selected from the group consisting of Co, Rh, Ni, Pd, C, Si, Ge, and Sn.

### Example 2

Table 3 described below shows the components of second aluminum alloy material film 135b. Furthermore, Table 4 described below also shows the results of determination as to whether Ni of second aluminum alloy material film 135b is diffused into semiconductor layer 134 located below metal film 135a in the case where metal film 135a is formed on the lower surface of second aluminum alloy material film 135b shown in Table 3. Specifically, Table 4 shows the results of determination as to whether Ni of second aluminum alloy material film 135b is diffused into semiconductor layer 134 in the case where metal film 135a is formed of titanium (Ti) and the case where metal film 135a is formed of molybdenum (Mo).

**[Table 3]**

| | Components Contained in Al Alloy | | | |
|---|---|---|---|---|
| | (Second Aluminum Alloy Material Film 135b) | | | |
| Metal | Al | Ni | Cu | La |
| Density | 2.7 | 8.9 | 8.89 | 6.15 |
| Determination | - | - | - | - |

**[Table 4]**

| | Underlying Layer (Metal Film 135a) | |
|---|---|---|
| Metal | Ti | Mo |
| Density | 4.54 | 10.2 |
| Determination | B | A |

| | | |
|---|---|---|
| B: Diffusion occurred in semiconductor layer A: Diffusion not occurred in semiconductor layer | | |

In Table 4 described above, "B" shows that it could be confirmed that "Ni" within second aluminum alloy material film 135b was diffused into semiconductor layer 134. Also in Table 4 described above, "A" shows that it could not be confirmed that "Ni" within second aluminum alloy material film 135b was diffused into semiconductor layer 134.

The analysis was made by ToF-SIMS (Time-of-flight secondary ion mass spectrometry) as to whether "Ni" was diffused into semiconductor layer 134 or not.

As a result, diffusion of "Ni" could be confirmed in the case where metal film 135a was formed of titanium while diffusion of "Ni" could not be confirmed in the case where metal film 135a was formed of molybdenum. In other words, it is recognized that metal film 135a is formed of molybdenum, thereby allowing diffusion of "Ni" to be suppressed and also allowing the performance of the thin film transistor to be ensured.

Furthermore, as shown in Tables 3 and 4 described above, the density of titanium (Ti) is 4.54 which is smaller than the density of each of elements Ni, Cu and La constituting a part of second aluminum alloy material film 135b. On the other hand, molybdenum (Mo) is greater in density than any of the elements constituting second aluminum alloy material film 135b.

In this way, as a result of earnest effort of study, the inventors have found that the elements greater in density than the elements constituting second aluminum alloy material film 135b are employed, so that the elements within second aluminum alloy material film 135b can be suppressed from being diffused into semiconductor layer 134.

### Example 3

Using the Secondary Ion Mass Spectrometry (SIMS), the inventors compared the case where an aluminum alloy material film was formed on the titanium (Ti) film with the case where the above-described aluminum alloy material film was formed on the Mo film. As a result of earnest effort of study by the inventors, it was found that Ni was diffused into the titanium (Ti) film at a content ratio of 40% in the aluminum alloy material film. In contrast, the example in which the above-described aluminum alloy material film was formed on the molybdenum (Mo) film showed that Ni was diffused into the molybdenum film at a content ratio of 1.0% or less in the aluminum alloy material film.

Thus, as a result of earnest effort of study by the inventors, it was found that Ni in the above-described aluminum alloy material film was hardly diffused when molybdenum was used. Thus, it is recognized that diffusion of Ni can be suppressed by disposing the metal film formed of molybdenum (Mo) between the aluminum alloy material film and the semiconductor film.

Although the embodiments and examples of the present invention have been described as above, it should be understood that the embodiments and examples disclosed herein are illustrative and non-restrictive in every respect. The scope of the present invention is defined by the terms of the claims, and is intended to include any modifications within the scope and meaning equivalent to the terms of the claims. Furthermore, the above-described numerical values are merely by way of example and not limited to the above-described numerical values and the ranges.

### INDUSTRIAL APPLICABILITY

The present invention can be applied to a liquid crystal display device and a method of manufacturing the liquid crystal display device.

### REFERENCE SIGNS LIST

101 liquid crystal display panel, 103 display region, 104 non-display region, 105 peripheral region, 107 pixel array region, 111 gate line, 112 gate pad, 113 source line, 114 source pad, 115 thin film transistor, 116 pixel electrode, 117 drain line, 118 drain pad portion, 119a precipitate, 119b base material, 123 transparent substrate, 125 contact, 125a contact hole, 129a precipitate, 129b base material, 130 active matrix substrate, 132 gate electrode, 133 gate insulating film, 134 semiconductor layer, 135b, 136b aluminum alloy material film, 135 source electrode, 136 drain electrode, 136a, 135a metal film, 137 passivation film, 138 planarizing film, 140 interlayer insulating film, 141 ITO film (transparent conductive film), 150 gate terminal portion, 151 source terminal portion, 152 gate driver, 153 source driver, 154 printed circuit board wiring, 155 display control circuit, 156 polarization plate, 170 contact hole, 175 contact hole, 176 contact hole, 183 opening, 184 operation circuit, 185 supporting member, 186 back light unit, 200 liquid crystal display element, 300 liquid crystal display device, 500 television receiver.

## Claims

1. A liquid crystal display device comprising:
a substrate (123) including a pixel array region and a peripheral region located outside of said pixel array region;
a switching element (115) formed in said pixel array region;
an electrode (132, 135) provided in said switching element;
a lead line (111, 113) connected to said switching element; and
a pad portion (112, 114) connected to said lead line,
at least one of said electrode, said lead line and said pad portion including an aluminum alloy material film,
said aluminum alloy material film including aluminum as a base material, an alloy component containing at least one type of element selected from the group consisting of cobalt, rhodium, nickel, palladium, carbon, silicon, germanium, and tin, and another component containing an element different from aluminum and each said element listed above, and
a total number of types of the elements of said alloy component and said another component being three or more.

2. The liquid crystal display device according to claim 1, wherein said aluminum alloy material film contains 0.5 wt% or more of said alloy component.

3. The liquid crystal display device according to claim 1 or 2, wherein said alloy component contained in said aluminum alloy material film is 4.5 wt% or less.

4. The liquid crystal display device according to any one of claims 1 to 3, wherein said aluminum alloy material film contains a conductive precipitate (119a, 129a).

5. The liquid crystal display device according to claim 4, wherein
the electrode of said switching element includes a drain electrode (136),
said liquid crystal display device further comprises a pixel electrode (116) connected to said drain electrode,
said drain electrode includes said aluminum alloy material film (136b),
said pixel electrode is connected to the aluminum alloy material film of said drain electrode, and
said precipitate is exposed in at least a portion of a surface of said aluminum alloy material film that is in contact with said pixel electrode.

6. The liquid crystal display device according to any one of claims 1 to 5, wherein
said switching element further includes a semiconductor layer (134),
said electrode of said switching element includes a source electrode (135) and a drain electrode (136) formed on said semiconductor layer,
said drain electrode and said source electrode each include said aluminum alloy material film (135b, 136b) and a metal film (135a, 136a) disposed between said aluminum alloy material film and said semiconductor layer, and
said metal film is formed of an element greater in density than the element of said alloy component and the element of said another component.

7. The liquid crystal display device according to claim 6, wherein said drain electrode and said source electrode each further include an intermediate film (135e, 136e) formed of aluminum and formed between said aluminum alloy material film and said metal film.

8. The liquid crystal display device according to claim 6 or 7, wherein said metal film is formed of molybdenum.

9. The liquid crystal display device according to any one of claims 1 to 8, wherein said pad portion is formed of said aluminum alloy material film.

10. The liquid crystal display device according to claim 9, further comprising a transparent conductive film (141, 142) formed on said pad portion, wherein
said pad portion is formed of said aluminum alloy material film,
said aluminum alloy material film includes a conductive precipitate, and
the conductive precipitate is exposed in a portion of a surface of said pad portion that is in contact with said transparent conductive film.

11. The liquid crystal display device according to claim 1, wherein
said electrode of said switching element includes a source electrode and a drain electrode,
said pad portion is formed of a first aluminum alloy material film,
said source electrode and said drain electrode each include a second aluminum alloy material film,
said first aluminum alloy material film includes aluminum as a base material, a first alloy component containing at least one type of element selected from the group consisting of cobalt, rhodium, nickel, palladium, carbon, silicon, germanium, and tin, and a first another component containing an element different from aluminum and each said element listed above, a total number of types of the elements of said first alloy component and said first another component being three or more,
said second aluminum alloy material film includes aluminum as a base material, a second alloy component containing at least one type of element selected from the group consisting of cobalt, rhodium, nickel, palladium, carbon, silicon, germanium, and tin, and a second another component containing an element different from aluminum and each said element listed above, a total number of types of the elements of said second alloy component and said second another component being three or more,
said first aluminum alloy material film includes a conductive first precipitate (129a),
said second aluminum alloy material film includes a conductive second precipitate (119a), and
said first precipitate is greater in distribution density than said second precipitate.

12. The liquid crystal display device according to claim 11, wherein said electrode of said switching element includes a source electrode (135) and a gate electrode (132),
said lead line includes a source line (113) connected to said source electrode and a gate line connected to said gate electrode,
said pad portion includes a source pad (114) connected to said source line and a gate pad (112) connected to said gate line, and
said source pad and said gate pad each are formed of said first aluminum alloy material film.

13. The liquid crystal display device according to claim 1, wherein
said switching element includes
a gate electrode (132) formed on a main surface of said substrate,
a semiconductor layer (134) formed on said gate electrode,
a source electrode (135) formed on said semiconductor layer, and
a drain electrode (136) formed on said semiconductor layer and spaced apart from said source electrode,
said lead line includes a gate line (111) connected to said gate electrode, and a source line (113) connected to said source electrode,
said pad portion includes a gate pad connected to said gate line, and a source pad connected to said source line, and
said gate electrode, said gate line and said gate pad each are formed of said aluminum alloy material film.

14. The liquid crystal display device according to claim 13, wherein said source electrode and said drain electrode each include said aluminum alloy material film.

15. A liquid crystal display device comprising:
a substrate (123) including a pixel array region and a peripheral region located outside of said pixel array region;
a switching element (115) formed in said pixel array region;
an electrode (132, 135) provided in said switching element;
a lead line (111, 113) connected to said switching element;
a pad portion (112, 114) connected to said lead line; and
a transparent conductive film (141, 142) formed on said pad portion,
at least one of said electrode, said lead line and said pad portion including an aluminum alloy material film, and
a potential difference between said aluminum alloy material film and said transparent conductive film being smaller than a potential difference between an aluminum film and said transparent conductive film.

16. A liquid crystal display device comprising:
a substrate including a pixel array region and a peripheral region located outside of said pixel array region;
a switching element formed in said pixel array region;
an electrode provided in said switching element;
a lead line connected to said switching element; and
a pad portion connected to said lead line,
at least one of said electrode, said lead line and said pad portion including an aluminum alloy material film, and
said aluminum alloy material film including aluminum as a base material, an alloy component containing at least one type of element selected from the group consisting of cobalt (Co), rhodium (Rh), nickel (Ni), palladium (Pd), carbon (C), silicon (Si), germanium (Ge), and tin (Sn), and another component containing at least one type of element selected from the group consisting of copper (Cu), a lanthanum (La), boron (B), neodymium (Nd), silver (Ag), gold (Au), platinum (Pt), yttrium (Y), niobium (Nb), tungsten (W), and zirconium (Zr).

17. A method of manufacturing a liquid crystal display device including a substrate including a pixel array region and a peripheral region located outside of said pixel array region, a switching element formed in said pixel array region, an electrode provided in said switching element, a lead line connected to said switching element, and a pad portion connected to said lead line, said method comprising the steps of:
preparing a substrate having a main surface;
forming an aluminum alloy material film including aluminum as a base material, an alloy component containing at least one type of element selected from the group consisting of cobalt, rhodium, nickel, palladium, carbon, silicon, germanium, and tin, and another component containing an element different from aluminum and each said element listed above, a total number of types of the elements of said alloy component and said another component being three or more; and
patterning said aluminum alloy material film to form at least one of said electrode, said lead line and said pad portion.

18. The method of manufacturing a liquid crystal display device according to claim 17, wherein said aluminum alloy material film contains 0.5 wt% or more of said alloy component.

19. The method of manufacturing a liquid crystal display device according to claim 17 or 18, wherein said alloy component contained in said aluminum alloy material film is 4.5 wt% or less.

20. The method of manufacturing a liquid crystal display device according to any one of claims 17 to 19, wherein said electrode is formed by patterning said aluminum alloy material film by wet etching.

21. The method of manufacturing a liquid crystal display device according to any one of claims 17 to 20, further comprising the steps of:
heating said aluminum alloy material film to form a precipitate within said aluminum alloy material film;
exposing said precipitate on a surface of said aluminum alloy material film; and
forming a transparent conductive film in a portion of the surface of said aluminum alloy material film in which said precipitate is exposed.

22. The method of manufacturing a liquid crystal display device according to any one of claims 17 to 21, wherein
said step of forming said electrode includes the steps of: forming said aluminum alloy material film on the main surface of said substrate; and patterning said aluminum alloy material film to form a gate electrode, and
said electrode is the gate electrode.

23. The method of manufacturing a liquid crystal display device according to claim 22, further comprising the step of forming a gate insulating film so as to cover said gate electrode, wherein
a conductive precipitate is formed within said aluminum alloy material film by heat for forming said gate insulating film.

24. The method of manufacturing a liquid crystal display device according to any one of claims 17 to 23, further comprising the steps of:
forming a gate electrode on the main surface of said substrate;
forming a gate insulating film so as to cover said gate electrode;
forming a semiconductor layer on said gate insulating film and above said gate electrode; and
forming, on said semiconductor layer, a metal film formed of an element greater in density than the element of said alloy component and the element of said another component, wherein
said step of forming the electrode includes the steps of: forming said aluminum alloy material film on said metal film; and patterning said aluminum alloy material film to form a source electrode and a drain electrode each as said electrode.

25. The method of manufacturing a liquid crystal display device according to claim 24, wherein said metal film is formed of molybdenum.

26. The method of manufacturing a liquid crystal display device according to claim 24 or 25, further comprising the step of forming an insulating film so as to cover said source electrode and said drain electrode, wherein
a precipitate is formed within said source electrode and said drain electrode by heat for forming said insulating film.

27. A method of manufacturing a liquid crystal display device including a substrate including a pixel array region and a peripheral region located outside of said pixel array region, a switching element formed in said pixel array region, an electrode provided in said switching element, a lead line connected to said switching element, and a pad portion connected to said lead line, said method comprising the steps of:
preparing a substrate having a main surface;
forming an aluminum alloy material film including aluminum as a base material, an alloy component containing at least one type of element selected from the group consisting of cobalt (Co), rhodium (Rh), nickel (Ni), palladium (Pd), carbon (C), silicon (Si), germanium (Ge), and tin (Sn), and another component containing at least one type of element selected from the group consisting of copper (Cu), lanthanum (La), boron (B), neodymium (Nd), silver (Ag), gold (Au), platinum (Pt), yttrium (Y), niobium (Nb), tungsten (W), and zirconium (Zr); and
patterning said aluminum alloy material film to form at least one of said electrode, said lead line and said pad portion.
